# EUROPEAN PATENT APPLICATION

(11) **EP 4 219 586 A1**
(43) Date of publication of application: **02.08.2023**
(21) Application number: 21872367.4
(22) Date of filing: 17.09.2021
(51) Int. Cl.: C08G 61/00, C09K 11/06, C08K 5/3415, C08L 65/00, C08L 101/00, H01L 51/50

(54) **THERMALLY-CROSSLINKABLE LOW MOLECULAR WEIGHT COMPOUND-CONTAINING COMPOSITION FOR LIGHT EMITTING DIODE**

(30) Priority: 23.09.2020 JP 2020158731
(71) Applicant: Hodogaya Chemical Co., Ltd., Tokyo, 105-0021 (JP)
(72) Inventor: SAEGUSA, Yuta, Tokyo 104-0028 (JP); SHINODA, Mika, Tokyo 104-0028 (JP); TOGASHI, Kazunori, Tokyo 104-0028 (JP); HIRAI, Hiroki, Tokyo 104-0028 (JP)
(74) Representative: Forstmeyer, Dietmar
(86) International application number: PCT/JP2021/034352
(87) International publication number: WO 2022/065238

(57) **Abstract**

It is an object of the present invention to provide a composition for light emitting diodes with which it is possible to obtain an organic EL element that includes an organic layer formed using a high molecular weight material and whose service life can be extended as compared with that of conventional organic EL elements. The present invention provides a composition for light emitting diodes containing a high molecular weight compound and a thermally crosslinkable low molecular weight compound, wherein the thermally crosslinkable low molecular weight compound includes a compound that has two or more thermally crosslinkable structures in a molecule. The thermally crosslinkable low molecular weight compound preferably includes a compound that contains two or more thermally crosslinkable structures selected from the group consisting of an acrylate structure, a methacrylate structure, and a maleimide structure in a molecule.

## Description

### Technical Field

The present invention relates to a composition for light emitting diodes and an organic electroluminescent element made using the composition.

### Background Art

Organic electroluminescent elements (hereinafter also referred to as "organic EL elements") that are one type of light emitting diode are self-emissive elements, and they are brighter, have superior display viewability, and can provide a clearer display, as compared with liquid crystal elements. For this reason, active studies have been carried out on organic electroluminescent elements.

An organic EL element includes a configuration in which a thin film formed using an organic compound (hereinafter also referred to as an "organic layer") is provided between a positive electrode and a negative electrode. The method for forming the thin film is roughly classified into a vacuum deposition method and an application method. The vacuum deposition method is a method in which a thin film is formed on a substrate in a vacuum by mainly using a low molecular weight compound, and is a technique that is already in practical use. On the other hand, the application method is a method in which a thin film is formed on a substrate by mainly using a high molecular weight compound based on a method that uses a solution such as an inkjet method or a printing method, and is a technique that has high material usage efficiency, is suitable for achieving a large area and high definition display and is therefore essential for future large area organic EL displays.

With the vacuum deposition method that uses a low molecular weight material, the material usage efficiency is very low. When producing a large-size display using the vacuum deposition method, the shadow mask warps significantly, which makes it difficult to perform uniform deposition on a large-size substrate. The vacuum deposition method also has the problem in that the production cost is high.

On the other hand, it is possible to form a uniform film even on a large-size substrate by applying a solution prepared by dissolving a high molecular weight material in an organic solvent. By utilizing this, the application method as typified by an inkjet method or a printing method can be used. Accordingly, the material usage efficiency can be increased, and the production cost required to produce an organic EL element can be significantly reduced.

Various types of organic EL elements produced using a high molecular weight material have been studied, but they were problematic in that the element characteristics such as light emission efficiency and service time were not always sufficient (see, for example, Patent Literatures 1 to 6).

Conventionally, a fluorene polymer called TFB has been known as a typical hole transport material used in an organic EL element that contains a polymer (see Patent Literatures 7 and 8). However, TFB has insufficient hole transport performance and electron blocking performance, and thus was problematic in that a portion of electrons pass through the light emitting layer, and an improvement in light emission efficiency cannot be expected. In addition, there was another problem in that, due to a low film adhesion to adjacent layers, the extension in the service time of the organic EL element cannot be expected, either.

Also, the inventors of the present application have developed various types of hole transport materials that can be used in high molecular weight organic EL elements (see Patent Literatures 9 to 10), but they were problematic in that the element service time was insufficient.

### Citation List

### Patent Literatures

Patent Literature 1: US 20080274303
Patent Literature 2: JP 2007-119763A
Patent Literature 3: US 20100176377
Patent Literature 4: Japanese Patent No. 5018043
Patent Literature 5: US 7651746
Patent Literature 6: US 20120256537
Patent Literature 7: EP 0988337
Patent Literature 8: US 8974917
Patent Literature 9: US 20190326515
Patent Literature 10: US 20190378989

### Summary of Invention

It is an object of the present invention to provide a composition for light emitting diodes with which it is possible to obtain an organic EL element that includes an organic layer formed using a high molecular weight material and whose service life can be extended as compared with that of conventional organic EL elements.

The inventors of the present application conducted in-depth studies and found that the service time of an organic EL element that includes an organic layer formed using a composition for light emitting diodes that contains a high molecular weight compound and a thermally crosslinkable low molecular weight compound can be extended, and the present invention has been accomplished based on the finding.

In the organic EL element according to the present invention, it is preferable that an organic layer formed using a composition for light emitting diodes that contains a high molecular weight compound and a thermally crosslinkable low molecular weight compound is used as a hole transport layer, an electron blocking layer, a hole injection layer, or a light emitting layer.

Specifically, the present invention includes the following configurations.
[1] A composition for light emitting diodes comprising:
   a high molecular weight compound; and
   a thermally crosslinkable low molecular weight compound,
   wherein the thermally crosslinkable low molecular weight compound comprises a compound that has two or more thermally crosslinkable structures in a molecule.
[2] The composition for light emitting diodes as set forth in clause [1],
   wherein the thermally crosslinkable low molecular weight compound comprises the compound that has two or more thermally crosslinkable structures selected from the group consisting of an acrylate structure, a methacrylate structure, and a maleimide structure in a molecule.
[3] The composition for light emitting diodes as set forth in clause [2],
   wherein the thermally crosslinkable low molecular weight compound comprises a compound represented by general formula (1) given below,
      [Chem. 1]

      A-L2-L1-L2-A (1)
   where L1 represents an arylene group, a heteroarylene group, an alkylene group, or a disulfide group,
   L2 represents an arylene group, a heteroarylene group, a disulfide group, or a single bond, and
   A represents a group selected from the group consisting of formula A1, formula A2, and formula A3 given below, and may represent the same or different groups, 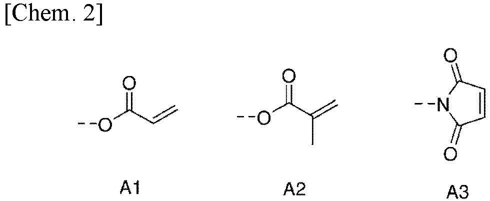
   where a broken line indicates a binding site.
[4] The composition for light emitting diodes as set forth in clause [3],
   wherein, in the general formula (1), L1 represents a phenylene group, a naphthalene group, or a biphenylene group, and L2 represents a single bond, or alternatively, L1 represents an alkylene group having 2 to 6 carbon atoms, and L2 represents a phenylene group or a naphthalene group.
[5] The composition for light emitting diodes as set forth in any one of clauses [1] to [4],
   wherein the high molecular weight compound contains a repeating unit that has a triarylamine structural unit represented by general formula (2) given below, and has a weight-average molecular weight in terms of polystyrene of 10,000 or more and less than 1,000,000, 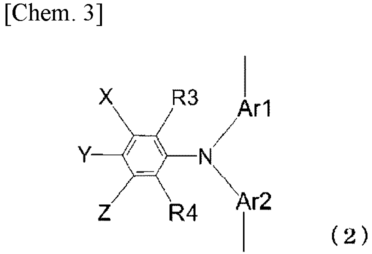
   where Ar1 and Ar2 each independently represent an arylene group or a heteroarylene group,
   R3 and R4 each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms,
   X, Y, and Z each independently represent an aryl group, a heteroaryl group, a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, with the proviso that at least one of X, Y, and Z represents an aryl group or a heteroaryl group.
[6] The composition for light emitting diodes as set forth in clause [5],
   wherein the high molecular weight compound comprises a copolymerized high molecular weight compound that further contains a repeating unit that has one or more structural units selected from the group consisting of structural units represented by general formulas (3a) to (3x) given below, 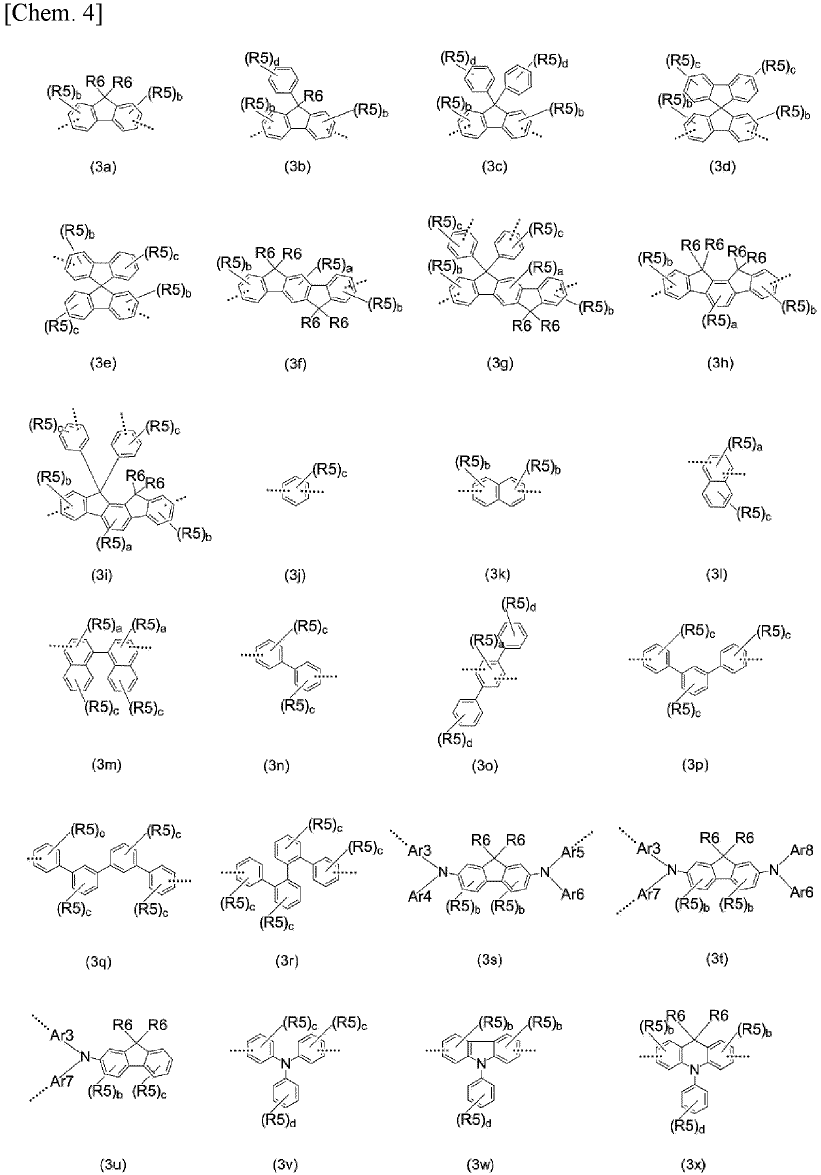
   where R5 represents a hydrogen atom, a heavy hydrogen atom, a cyano group, a nitro group, a fluorine atom, a chlorine atom, a bromine atom, an iodine atom, an alkyl group having 1 to 40 carbon atoms, a cycloalkyl group having 3 to 40 carbon atoms, an alkyloxy group having 1 to 40 carbon atoms, a cycloalkyloxy group having 3 to 40 carbon atoms, a thioalkyloxy group having 1 to 40 carbon atoms, an alkenyl group having 2 to 40 carbon atoms, or an aryloxy group having 6 to 40 carbon atoms,
   R6 represents an alkyl group having 1 to 40 carbon atoms, a cycloalkyl group having 3 to 40 carbon atoms, an alkyloxy group having 1 to 40 carbon atoms, a thioalkyloxy group having 1 to 40 carbon atoms, or a cycloalkyloxy group having 3 to 40 carbon atoms,
   Ar3, Ar5, and Ar7 each independently represent an arylene group or a heteroarylene group,
   Ar4, Ar6, and Ar8 each independently represent an aryl group or a heteroaryl group,
   a to d represent the number of R5,
   a represents an integer of 0 to 2,
   b represents an integer of 0 to 3,
   c represents an integer of 0 to 4, and
   d represents an integer of 0 to 5.
[7] The composition for light emitting diodes as set forth in clause [5] or [6],
   wherein the high molecular weight compound comprises a copolymerized high molecular weight compound that further contains a repeating unit that has one or more thermally crosslinkable structural units selected from the group consisting of thermally crosslinkable structural units represented by general formulas (4a) to (4z) given below, 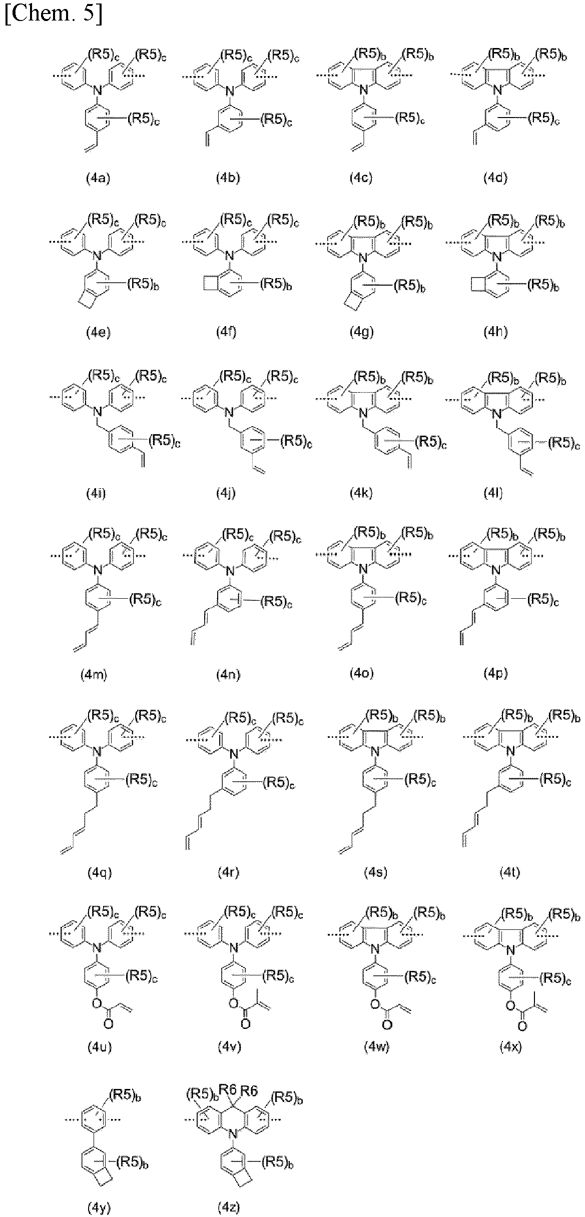
   where R5, R6, a, b, and c represent the same as those of the general formulas (3a) to (3x) given above.
[8] The composition for light emitting diodes as set forth in any one of clauses [1] to [7],
   wherein the high molecular weight compound comprises a high molecular weight compound that contains a repeating unit that has a triarylamine structural unit represented by general formula (5) given below and a repeating unit that has a connecting structural unit represented by general formula (6) given below, and has a weight-average molecular weight in terms of polystyrene of 10,000 or more and less than 1,000,000, 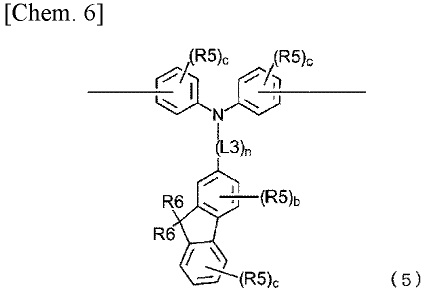 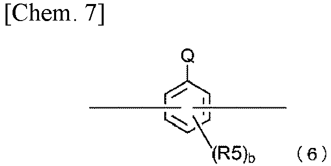 where R5, R6, b, and c represent the same as those of the general formulas (3a) to (3x) given above,
   Q represents a hydrogen atom, a heavy hydrogen atom, an amino group, an aryl group, or a heteroaryl group,
   L3 represents a phenylene group, and
   n represents an integer of 0 to 3.
[9] The composition for light emitting diodes as set forth in any one of clauses [1] to [8],
   wherein the high molecular weight compound comprises a copolymerized high molecular weight compound that contains a repeating unit represented by general formula (7) given below. 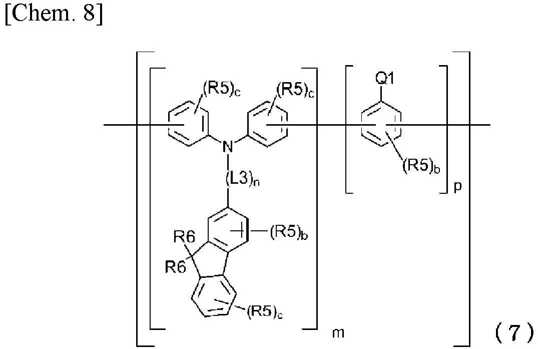
   where R5, R6, b, and c represent the same as those of the general formulas (3a) to (3x) given above,
   Q1 represents a hydrogen atom, a heavy hydrogen atom, an amino group, an aryl group, or a heteroaryl group,
   L3 represents a phenylene group,
   n represents an integer of 0 to 3,
   m represents a mole fraction of 0.1 to 0.9, and
   p represents a mole fraction of 0.1 to 0.9.
[10] The composition for light emitting diodes as set forth in clause [1], comprising two or more high molecular weight compounds.
[11] A composition for organic electroluminescent elements, comprising the composition for light emitting diodes as set forth in any one of clauses [1] to [10].
[12] An organic electroluminescent element comprising:
   a pair of electrodes; and
   at least one organic layer provided between the pair of electrodes,
   wherein the organic layer is formed using the composition for organic electroluminescent elements as set forth in clause [11].
[13] The organic electroluminescent element as set forth in clause [12],
   wherein the organic layer is a hole transport layer.
[14] The organic electroluminescent element as set forth in clause [12],
   wherein the organic layer is an electron blocking layer.
[15] The organic electroluminescent element as set forth in clause [12],
   wherein the organic layer is a hole injection layer.
[16] The organic electroluminescent element as set forth in clause [12],
   wherein the organic layer is a light emitting layer.

According to the present invention, it is possible to provide a composition for light emitting diodes that can extend the service time of an organic electroluminescent element.

### Brief Description of Drawings

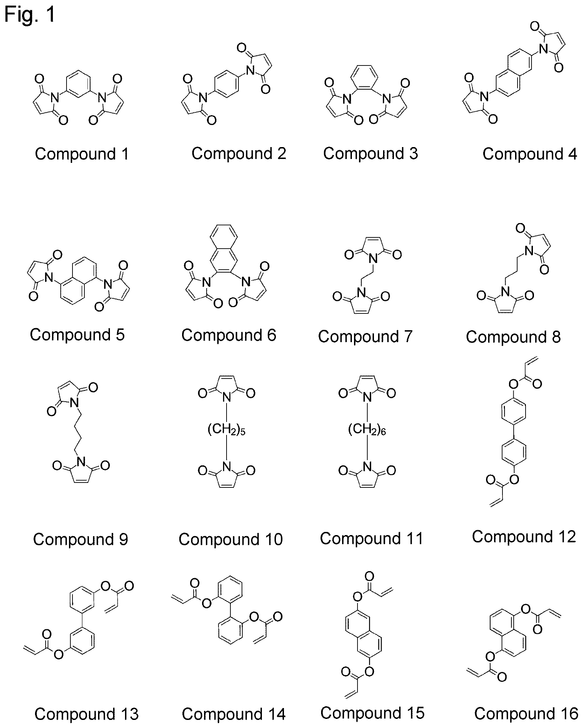

[Fig. 1] Fig. 1 is a diagram showing the chemical structures of compounds 1 to 16 that can preferably be used as a thermally crosslinkable low molecular weight compound in the present invention.

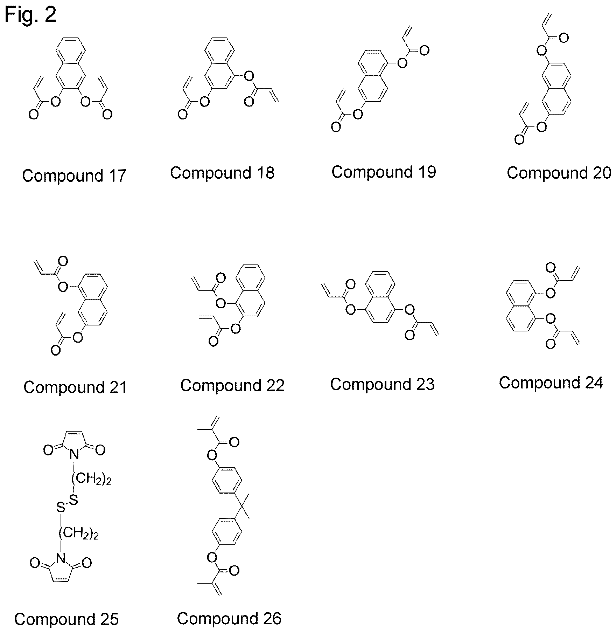

[Fig. 2] Fig. 2 is a diagram showing the chemical structures of compounds 17 to 26 that can preferably be used as the thermally crosslinkable low molecular weight compound in the present invention.
[Fig. 3] Fig. 3 is a diagram showing the chemical structures of structural units 1 to 9 that can preferably be used as a triarylamine structural unit represented by general formula (2) that is contained in a high molecular weight compound of the present invention.
[Fig. 4] Fig. 4 is a diagram showing the chemical structures of structural units 10 to 18 that can preferably be used as the triarylamine structural unit represented by the general formula (2) that is contained in the high molecular weight compound of the present invention.
[Fig. 5] Fig. 5 is a diagram showing the chemical structures of structural units 19 to 26 that can preferably be used as the triarylamine structural unit represented by the general formula (2) that is contained in the high molecular weight compound of the present invention.
[Fig. 6] Fig. 6 is a diagram showing the chemical structures of structural units 27 to 32 that can preferably be used as the triarylamine structural unit represented by the general formula (2) that is contained in the high molecular weight compound of the present invention.
[Fig. 7] Fig. 7 is a diagram showing the chemical structures of structural units 33 to 38 that can preferably be used as the triarylamine structural unit represented by the general formula (2) that is contained in the high molecular weight compound of the present invention.
[Fig. 8] Fig. 8 is a diagram showing the chemical structures of structural units 39 to 47 that can preferably be used as the triarylamine structural unit represented by the general formula (2) that is contained in the high molecular weight compound of the present invention.
[Fig. 9] Fig. 9 is a diagram showing the chemical structures of structural units 48 to 56 that can preferably be used as the triarylamine structural unit represented by the general formula (2) that is contained in the high molecular weight compound of the present invention.
[Fig. 10] Fig. 10 is a diagram showing the chemical structures of structural units 57 to 68 that can preferably be used as the triarylamine structural unit represented by the general formula (2) that is contained in the high molecular weight compound of the present invention.
[Fig. 11] Fig. 11 is a diagram showing the chemical structures of structural units 69 to 79 that can preferably be used as the triarylamine structural unit represented by the general formula (2) that is contained in the high molecular weight compound of the present invention.
[Fig. 12] Fig. 12 is a diagram showing the chemical structures of structural units 80 to 88 that can preferably be used as the triarylamine structural unit represented by the general formula (2) that is contained in the high molecular weight compound of the present invention.
[Fig. 13] Fig. 13 is a diagram showing the chemical structures of structural units 89 to 99 that can preferably be used as the triarylamine structural unit represented by the general formula (2) that is contained in the high molecular weight compound of the present invention.
[Fig. 14] Fig. 14 is a diagram showing the chemical structures of structural units 100 to 108 that can preferably be used as the triarylamine structural unit represented by the general formula (2) that is contained in the high molecular weight compound of the present invention.
[Fig. 15] Fig. 15 is a diagram showing the chemical structures of structural units 109 to 117 that can preferably be used as the triarylamine structural unit represented by the general formula (2) that is contained in the high molecular weight compound of the present invention.
[Fig. 16] Fig. 16 is a diagram showing the chemical structures of structural units 118 to 126 that can preferably be used as the triarylamine structural unit represented by the general formula (2) that is contained in the high molecular weight compound of the present invention.
[Fig. 17] Fig. 17 is a diagram showing the chemical structures of structural units 127 to 135 that can preferably be used as the triarylamine structural unit represented by the general formula (2) that is contained in the high molecular weight compound of the present invention.
[Fig. 18] Fig. 18 is a diagram showing the chemical structures of structural units 136 to 144 that can preferably be used as the triarylamine structural unit represented by the general formula (2) that is contained in the high molecular weight compound of the present invention.
[Fig. 19] Fig. 19 is a diagram showing the chemical structures of structural units 145 to 156 that can preferably be used as the triarylamine structural unit represented by the general formula (2) that is contained in the high molecular weight compound of the present invention.
[Fig. 20] Fig. 20 is a diagram showing the chemical structures of structural units 157 to 165 that can preferably be used as the triarylamine structural unit represented by the general formula (2) that is contained in the high molecular weight compound of the present invention.
[Fig. 21] Fig. 21 is a diagram showing the chemical structures of structural units 201 to 220 that can preferably be used as a connecting structural unit represented by general formula (6) that is contained in the high molecular weight compound of the present invention.
[Fig. 22] Fig. 22 is a diagram showing the chemical structures of structural units 221 to 232 that can preferably be used as the connecting structural unit represented by the general formula (6) that is contained in the high molecular weight compound of the present invention.
[Fig. 23] Fig. 23 is a diagram showing an example of a layer configuration of an organic EL element according to the present invention.
[Fig. 24] Fig. 24 is ¹H-NMR chart of a high molecular weight compound I synthesized in Example 1.
[Fig. 25] Fig. 25 is ¹H-NMR chart of a high molecular weight compound II synthesized in Example 2.

### Description of Embodiments

### Composition for Light Emitting Diodes

A composition for light emitting diodes according to the present invention contains a high molecular weight compound and a thermally crosslinkable low molecular weight compound. As used herein, the term "a composition for light emitting diodes" refers to a composition that can form an organic layer for a light emitting diode such as a quantum dot light emitting element or an organic electroluminescent element.

### Thermally Crosslinkable Low Molecular Weight Compound

The thermally crosslinkable low molecular weight compound used in the present invention is a compound (hereinafter also referred to as a "compound A") that has two or more thermally crosslinkable structures in a molecule and forms a crosslinked structure with a high molecular weight compound that has a thermally crosslinkable structural unit through heating. There is no particular limitation on the compound A. However, for example, a compound that has two or more thermally crosslinkable structures selected from the group consisting of an acrylate structure, a methacrylate structure, and a maleimide structure in a molecule may be used.

The compound A may be, for example, a compound represented by general formula (1) given below.
[Chem. 9]

A-L2-L1-L2-A (1)

where L1 represents an arylene group, a heteroarylene group, an alkylene group, or a disulfide group,
L2 represents an arylene group, a heteroarylene group, a disulfide group, or a single bond, and
A represents a group selected from the group consisting of formulas A1, A2, and A3 given below, and may represent the same or different groups. 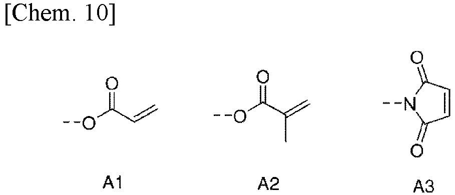
where a broken line indicates a binding site.

In the general formula (1), the arylene group is a divalent group, and may be a monocyclic ring, or a fused ring. Examples of the arylene group include a phenylene group, a naphthylene group, an anthranilene group, a phenanthrenilene group, a fluorenylene group, an indenylene group, a pyrenylene group, a perylenylene group, and the like. These arylene groups may each contain a substituent.

In the general formula (1), the heteroarylene group is a divalent group, and may be a monocyclic ring, or a fused ring. Examples of the heteroarylene group include a pyridinylene group, a pyrimidinylene group, a triazinylene group, a quinolinylene group, an isoquinolinylene group, a benzofuranylene group, a benzothiophenylene group, an indolylene group, a carbazolylene group, a benzoxazolylene group, a benzothiazolylene group, a quinoxalinylene group, a benzimidazolylene group, a pyrazolylene group, a dibenzofuranylene group, a dibenzothiophenylene group, a naphthyridinylene group, a phenanthrolinylene group, an acridinylene group, a carbolinylene group, and the like. These heteroarylene groups may each contain a substituent.

In the general formula (1), there is no particular limitation on the alkylene group, but the alkylene group may be a linear or branched alkylene group having 1 to 40 carbon atoms. Examples of the alkylene group include a methylene group, an ethylene group, an n-propylene group, an isopropylene group, an n-butylene group, a sec-butylene group, a tert-butylene group, an n-hexylene group, an n-pentylene group, an isopentylene group, a neopentylene group, a sec-pentylene group, a tert-pentylene group, a 3-pentylene group, an n-octylene group, an n-dodecylene group, and the like. These alkylene groups may each contain a substituent.

Examples of the substituents that may be contained in the arylene group, the heteroarylene group, and the alkylene group of the general formula (1) may include a heavy hydrogen atom, a cyano group, a nitro group, and the like. Other examples include the following groups:
halogen atoms such as a fluorine atom, a chlorine atom, a bromine atom, and an iodine atom;
alkyl groups, specifically, an alkyl group having 1 to 8 carbon atoms, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group;
alkyloxy groups, specifically, an alkyloxy group having 1 to 8 carbon atoms, a methyloxy group, an ethyloxy group, a propyloxy group, a phenyloxy group, and a tolyloxy group;
alkenyl groups such as a vinyl group and an allyl group;
aryl groups such as a phenyl group, a biphenyl group, a terphenyl group, a naphthyl group, an anthracenyl group, a phenanthrenyl group, a fluorenyl group, an indenyl group, a pyrenyl group, a perylenyl group, a fluoranthenyl group, and a triphenyl group;
heteroaryl groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, and a carbolinyl group;
arylvinyl groups such as a styryl group and a naphthylvinyl group; and
acyl groups such as an acetyl group and a benzoyl group.

These substituents may further contain any of the substituents listed above as examples. Furthermore, it is preferable that these substituents are each independently present, but these substituents may be bonded to each other to form a ring via a single bond, a methylene group that may contain a substituent, an oxygen atom, or a sulfur atom.

In the general formula (1), it is preferable that L1 represents a phenylene group, a naphthalene group, or a biphenylene group, and L2 represents a single bond, or alternatively, L1 represents an alkylene group having 2 to 6 carbon atoms, and L2 represents a phenylene group or a naphthalene group. In particular, it is preferable that L1 represents a phenylene group, and L2 represents a single bond, or alternatively, L1 represents an alkylene group having 2 to 6 carbon atoms, and L2 represents a phenylene group. With this configuration, in particular, the service time of the organic electroluminescent element can be further extended.

### High Molecular Weight Compound

The high molecular weight compound used in the present invention may be a homopolymer or a copolymer. There is no particular limitation on the high molecular weight compound. However, for example, the high molecular weight compound may contain, in a repeating unit, a triarylamine structural unit, any of structural units represented by general formulas (3a) to (3x), a thermally crosslinkable structural unit, and a connecting structural unit, which will be described later. These structural units may each form a repeating unit alone or in combination of a plurality of different structural units. The high molecular weight compound has good hole injection characteristics, a high hole mobility, excellent electron blocking ability, and is stable in the form of a thin film, and highly heat resistant. Accordingly, it is preferable that the high molecular weight compound contains a repeating unit that has a triarylamine structural unit.

### Triarylamine Structural Unit

The triarylamine structural unit is preferably a structural unit represented by general formula (2) given below. 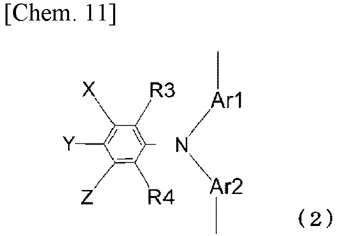
where Ar1 and Ar2 each independently represent an arylene group or a heteroarylene group,
R3 and R4 each independently represent a hydrogen atom, heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms,
X, Y, and Z each independently represent an aryl group, a heteroaryl group, a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, with the proviso that at least one of X, Y, and Z represents an aryl group or a heteroaryl group.

In the general formula (2), Ar1 and Ar2 each independently represent an arylene group or a heteroarylene group, and Ar1 and Ar2 may represent the same group.

An aromatic ring contained in the arylene group may be a monocyclic ring or a fused ring. Examples of the aromatic ring include a benzene ring, a naphthalene ring, an anthracene ring, a phenanthrene ring, a fluorene ring, an indene ring, a pyrene ring, a perylene ring, and the like.

A heterocycle contained in the heteroarylene group may also be a monocyclic ring or a fused ring. Examples of the heterocycle include a pyridine ring, a pyrimidine ring, a triazine ring, a quinoline ring, an isoquinoline ring, a benzofuran ring, a benzothiophene ring, an indole ring, a carbazole ring, a benzooxazole ring, a benzothiazole ring, a quinoxaline ring, a benzoimidazole ring, a pyrazoline ring, a dibenzofuran ring, a dibenzothiophene ring, a naphthyridine ring, a phenanthroline ring, an acridine ring, a carboline ring, and the like.

Ar1 and Ar2 may contain a substituent. Examples of the substituents that may be contained in Ar1 and Ar2 may include a heavy hydrogen atom, a cyano group, a nitro group, and the like. Other examples include the following groups:
halogen atoms such as a fluorine atom, a chlorine atom, a bromine atom, and an iodine atom;
alkyl groups, specifically, an alkyl group having 1 to 8 carbon atoms, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group;
alkyloxy groups, specifically, an alkyloxy group having 1 to 8 carbon atoms, a methyloxy group, an ethyloxy group, a propyloxy group, a phenyloxy group, and a tolyloxy group;
alkenyl groups such as a vinyl group and an allyl group;
aryl groups such as a phenyl group, a biphenyl group, a terphenyl group, a naphthyl group, an anthracenyl group, a phenanthrenyl group, a fluorenyl group, an indenyl group, a pyrenyl group, a perylenyl group, a fluoranthenyl group, and a triphenyl group;
heteroaryl groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, and a carbolinyl group;
arylvinyl groups such as a styryl group and a naphthylvinyl group; and
acyl groups such as an acetyl group and a benzoyl group.

These substituents may further contain any of the substituents listed above as examples.

It is preferable that the substituents that may be contained in Ar1 and Ar2 are each independently present, but these substituents may be bonded to each other to form a ring via a single bond, a methylene group that may contain a substituent, an oxygen atom, or a sulfur atom.

Ar1 and Ar2 each preferably represent a naphthyl group, a phenanthrenyl group, a dibenzofuranyl group, a dibenzothienyl group, and a fluorenyl group having a substituent, and most preferably represent an unsubstituted phenyl group. Preferred examples of the substituent of the fluorenyl group include a methyl group, an ethyl group, an n-propyl group, an n-butyl group, an n-pentyl group, an n-hexyl group, an n-heptyl group, an n-octyl group, and a phenyl group.

In the general formula (2), R3 and R4 each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, and R3 and R4 may represent the same atom or group.

Examples of the alkyl group, the cycloalkyl group, the alkenyl group, the alkyloxy group, and the cycloalkyloxy group described above include the following groups:
alkyl groups (C ₁ to C ₈) such as a methyl group, an ethyl group, an n-propyl group, an isopropyl group, an n-butyl group, an isobutyl group, a tert-butyl group, an n-pentyl group, an isopentyl group, a neopentyl group, an n-hexyl group, and an n-octyl group;
cycloalkyl groups (C ₅ to C ₁₀) such as a cyclopentyl group, a cyclohexyl group, a 1-adamantyl group, and a 2-adamantyl group;
alkenyl groups (C ₂ to C ₆) such as a vinyl group, an allyl group, an isopropenyl group, and a 2-butenyl group;
alkyloxy groups (C ₁ to C ₆) such as a methoxy group, an ethoxy group, an n-propoxy group, an isopropoxy group, an n-butoxy group, a tert-butoxy group, an n-pentyloxy group, and an n-hexyloxy group; and
cycloalkyloxy groups (C ₅ to C ₁₀) such as a cyclopentyloxy group, a cyclohexyloxy group, a cycloheptyloxy group, a cyclooctyloxy group, a 1-adamantyloxy group, and a 2-adamantyloxy group.

R3 and R4 may each contain a substituent. Examples of the substituents that may be contained in R3 and R4 may be the same groups as those of the substituents that may be contained in Ar1 and Ar2, and these substituents may further contain a substituent, as with Ar1 and Ar2.

It is preferable that the substituents that may be contained in R3 and R4 are each independently present, but these substituents may be bonded to each other to form a ring, as with the substituents that may be contained in Ar1 and Ar2.

R3 and R4 each preferably represent a hydrogen atom and a heavy hydrogen atom, and most preferably represent a hydrogen atom from the viewpoint of synthesis.

In the general formula (2), X, Y, and Z may represent the same group, and X, Y, and Z may each independently represent an aryl group, a heteroaryl group, a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, with the proviso that at least one of X, Y, and Z represents an aryl group or a heteroaryl group.

Examples of the alkyl group, the cycloalkyl group, the alkenyl group, the alkyloxy group, and the cycloalkyloxy group described above may be the same groups as those listed for R3 and R4 above. Examples of the aryl group and the heteroaryl group include the following groups:
aryl groups such as a phenyl group, a naphthyl group, an anthracenyl group, a phenanthrenyl group, a triphenyl group, a fluorenyl group, an indenyl group, a pyrenyl group, a perylenyl group, and a fluoranthenyl group; and
heteroaryl groups such as a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, a naphthyridinyl group, a phenanthrolinyl group, an acridinyl group, and a carbolinyl group.

Also, X, Y, and Z may each contain a substituent. Examples of the substituents that may be contained in X, Y, and Z may be the same groups as those of the substituents that may be contained in Ar1 and Ar2, and these substituents may further contain a substituent, as with Ar1 and Ar2.

For example, the aryl group and the heteroaryl group may each contain a phenyl group as a substituent, and the phenyl group may further contain a phenyl group as a substituent. That is, in the case where the aryl group is, for example, a phenyl group, the aryl group may be a biphenylyl group or a terphenylyl group.

The substituents that may be contained in X, Y, and Z may each be independently present, or bonded to each other or bonded to X, Y, or Z to form a ring.

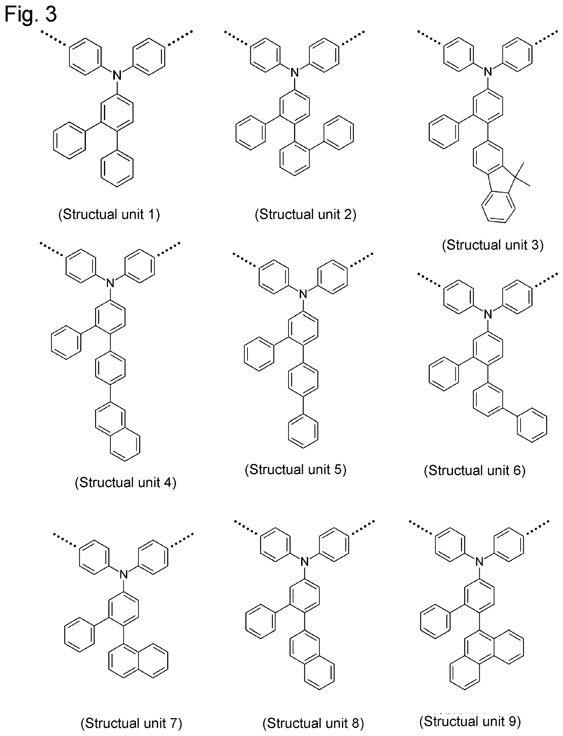

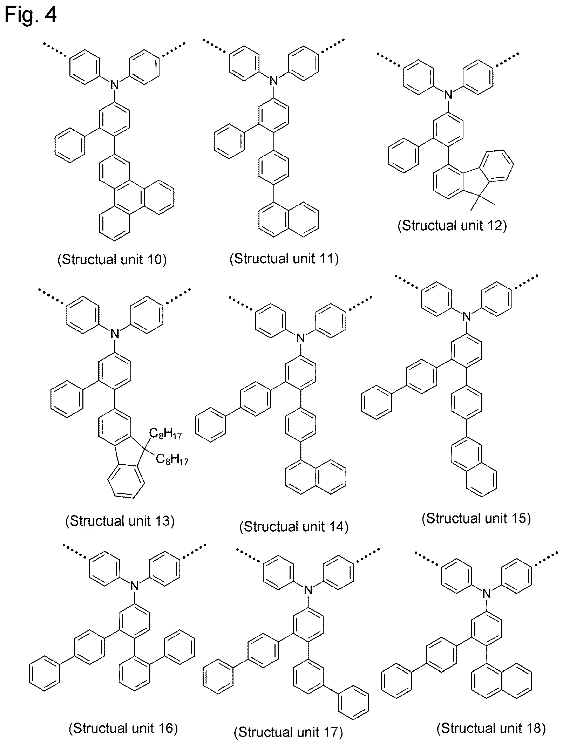

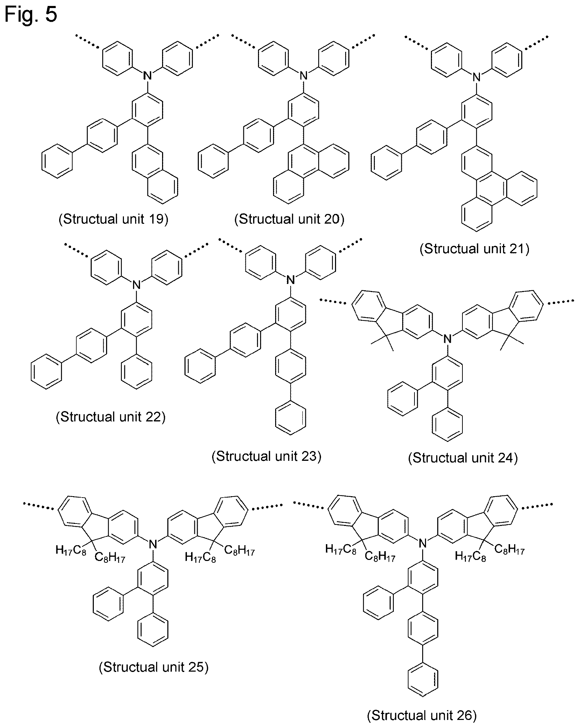

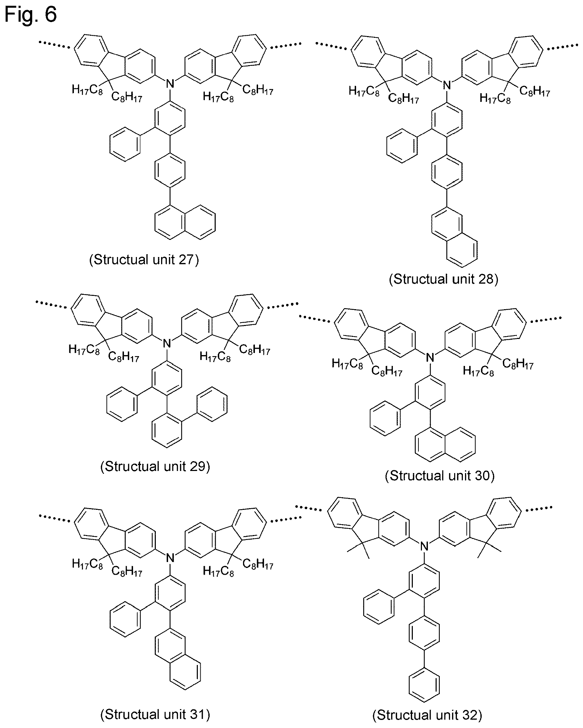

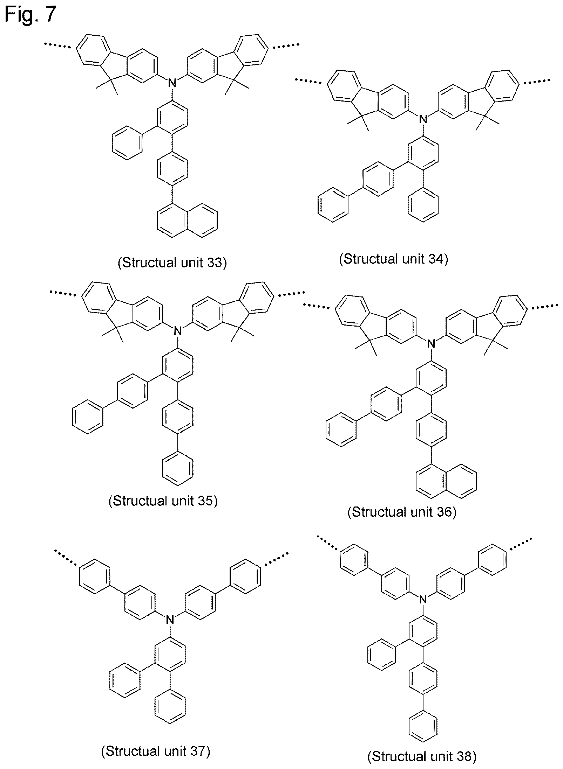

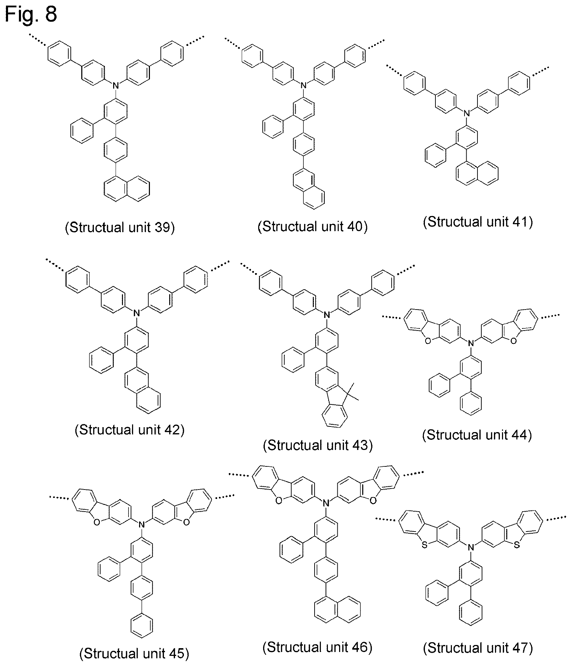

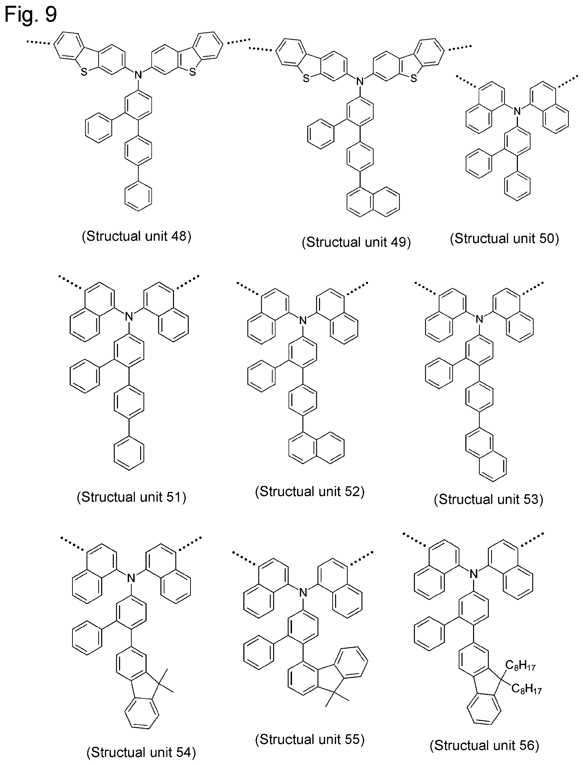

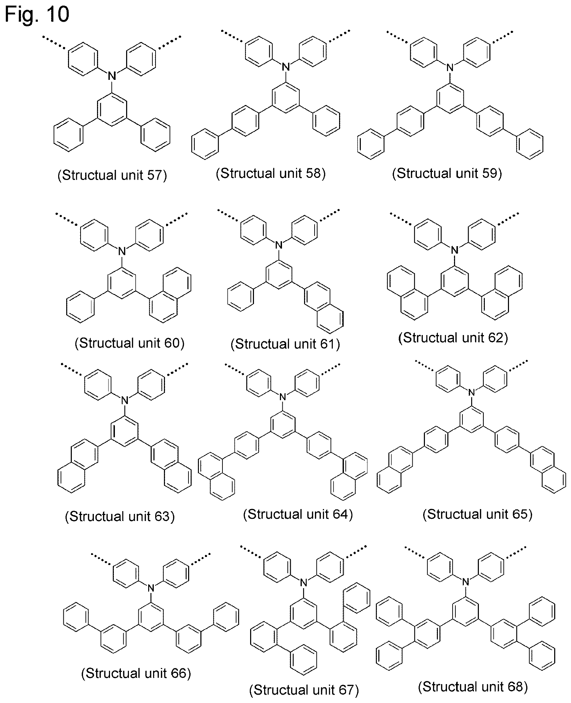

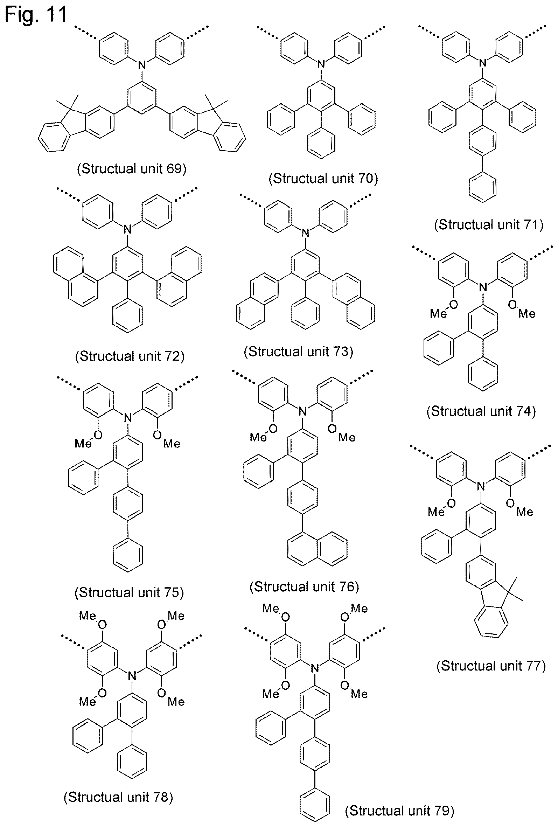

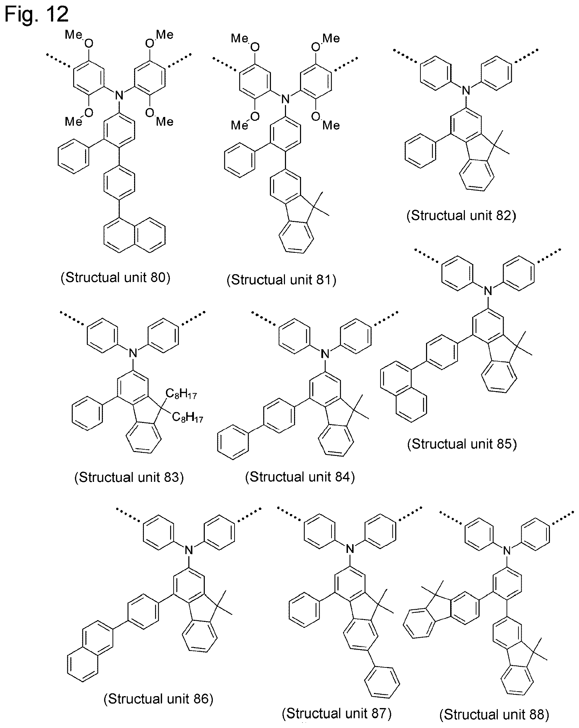

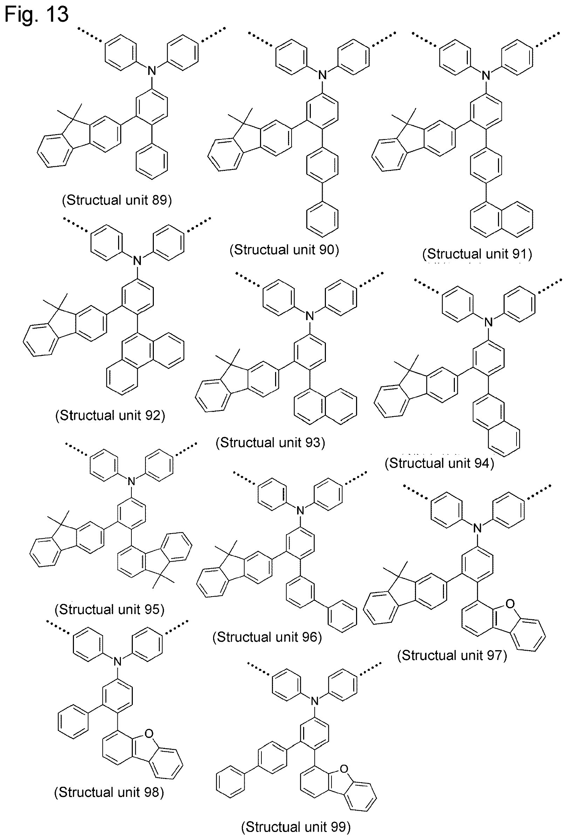

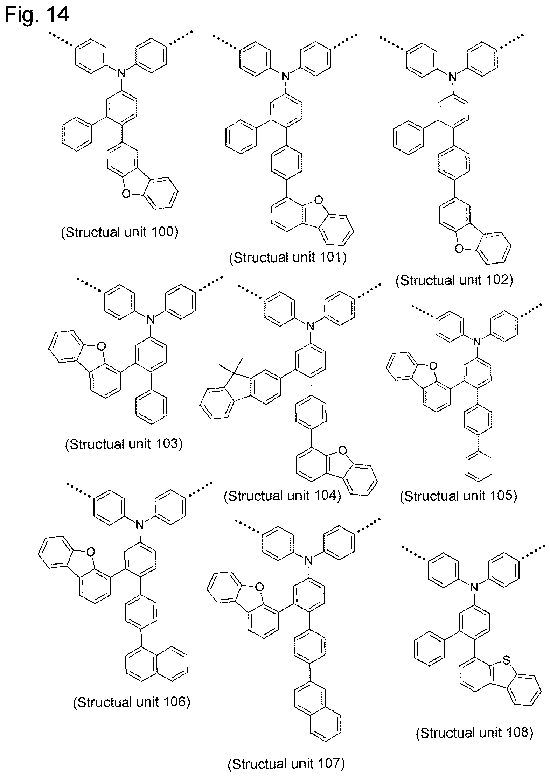

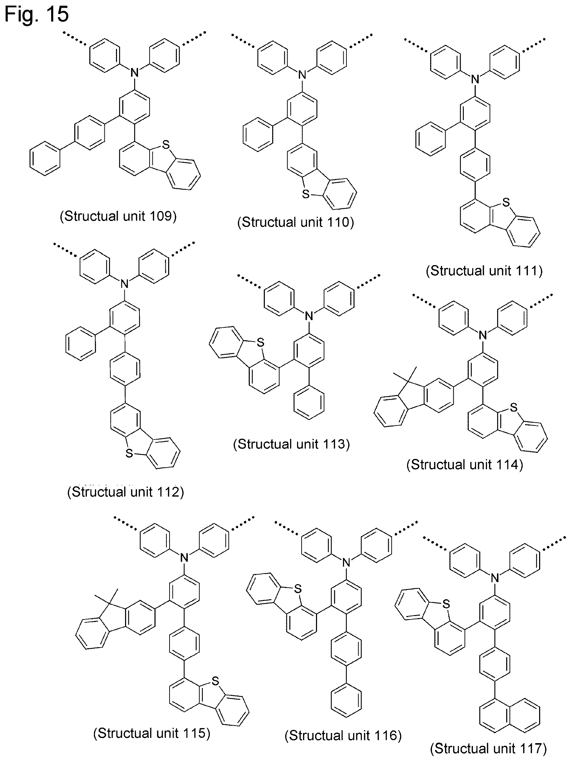

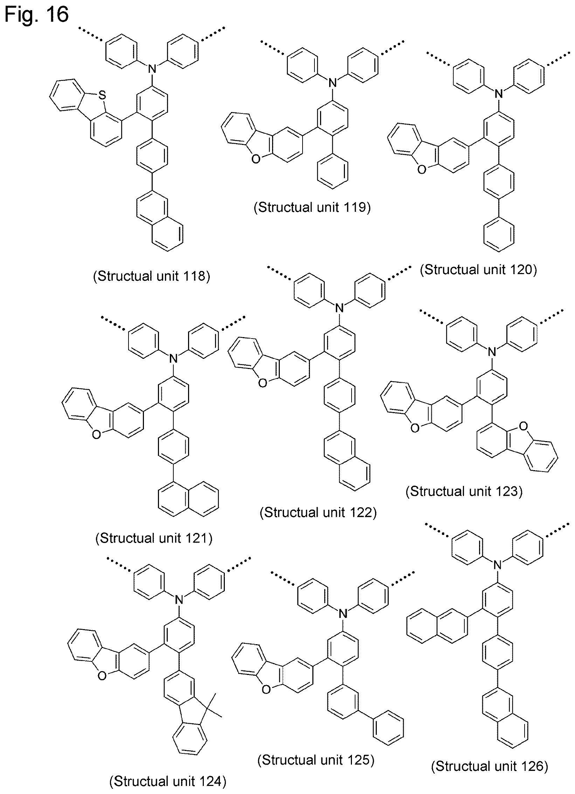

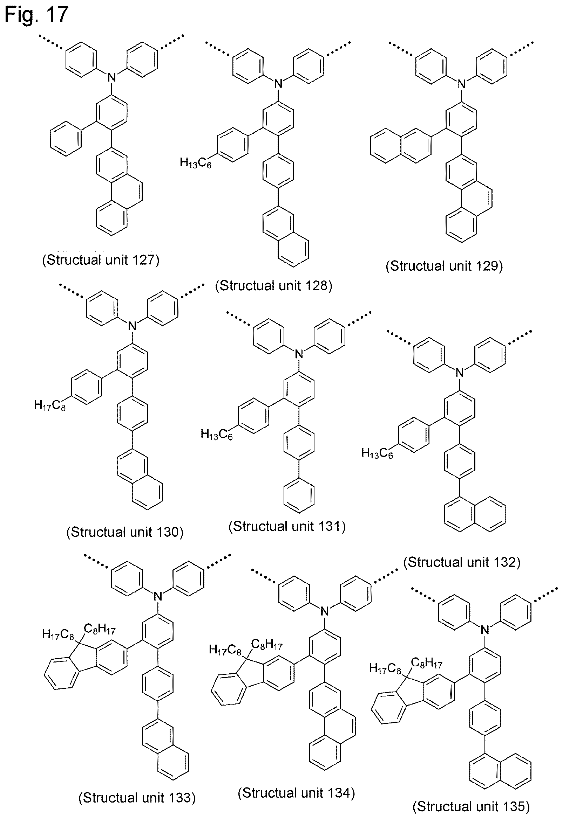

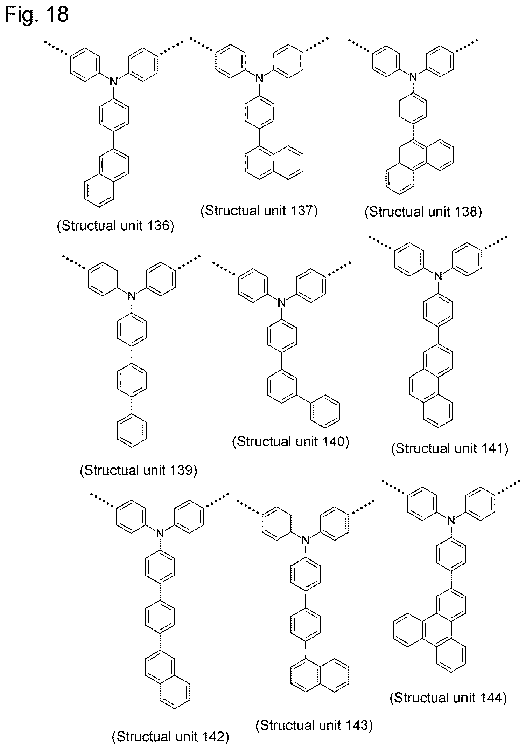

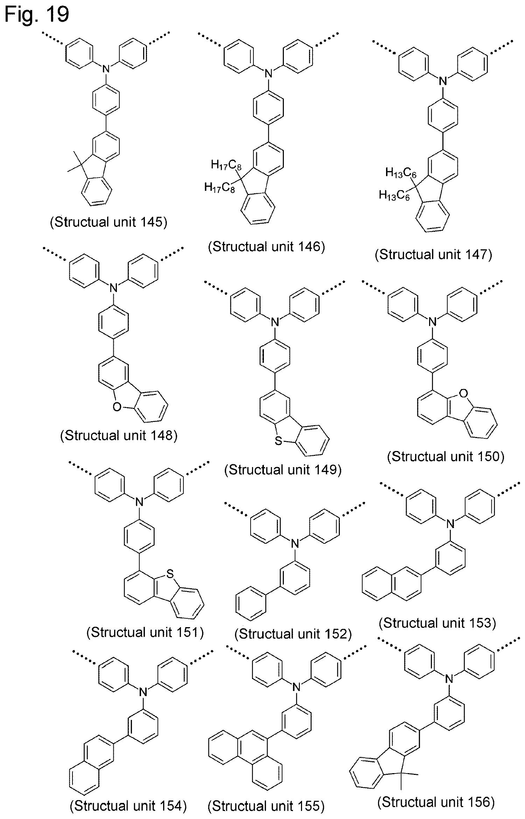

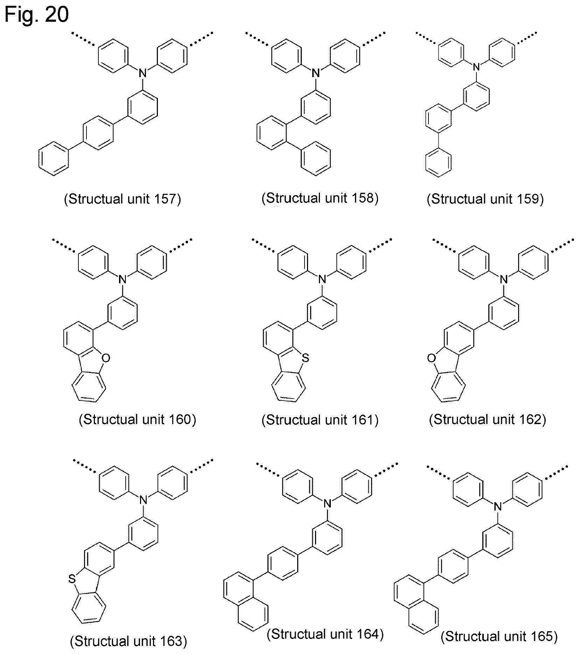

Specific examples of a substituted triarylamine structural unit represented by the general formula (2) given above that is a constituent unit of the high molecular weight compound are shown in Figs. 3 to 20 as structural units 1 to 165. In the chemical formulas shown in Figs. 3 to 20, a broken line indicates a bond to an adjacent structural unit.

### Structural Units Represented by General Formulas (3a) to (3x)

The high molecular weight compound may contain a repeating unit that has one or more structural units selected from the group consisting of structural units represented by general formulas (3a) to (3x) given below. 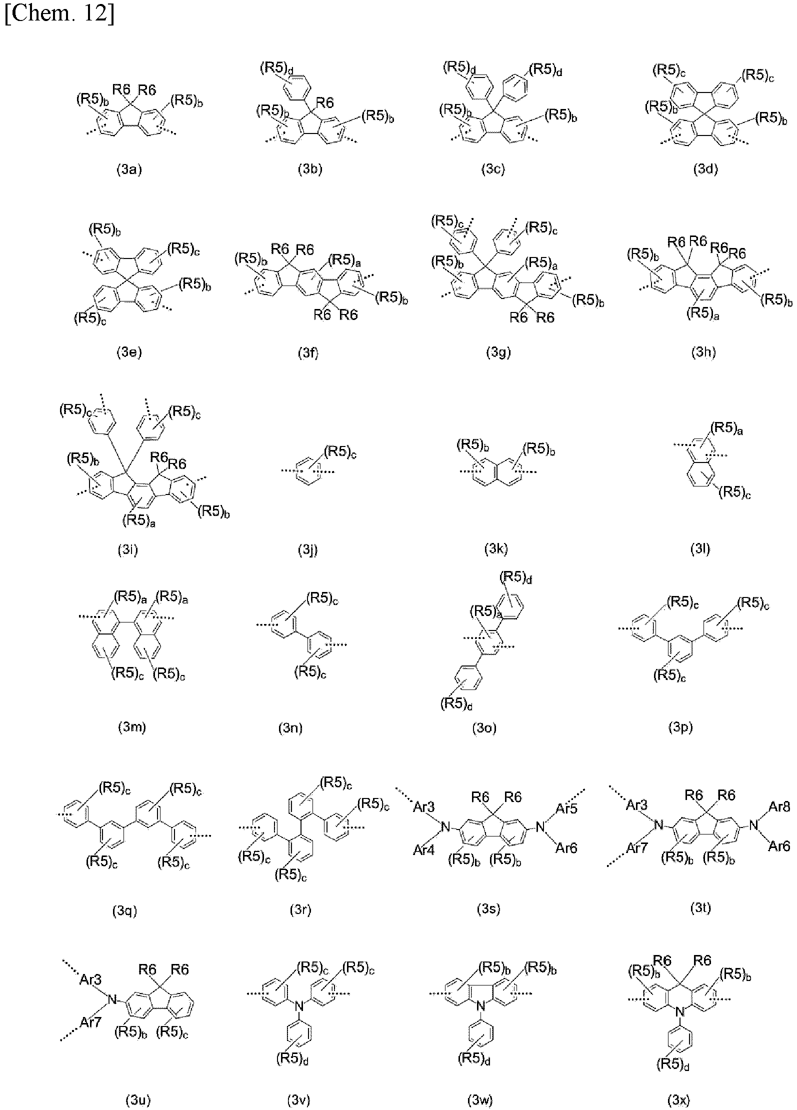
where R5 represents a hydrogen atom, a heavy hydrogen atom, a cyano group, a nitro group, a fluorine atom, a chlorine atom, a bromine atom, an iodine atom, an alkyl group having 1 to 40 carbon atoms, a cycloalkyl group having 3 to 40 carbon atoms, an alkyloxy group having 1 to 40 carbon atoms, a cycloalkyloxy group having 3 to 40 carbon atoms, a thioalkyloxy group having 1 to 40 carbon atoms, an alkenyl group having 2 to 40 carbon atoms, or an aryloxy group having 6 to 40 carbon atoms,
R6 represents an alkyl group having 1 to 40 carbon atoms, a cycloalkyl group having 3 to 40 carbon atoms, an alkyloxy group having 1 to 40 carbon atoms, a thioalkyloxy group having 1 to 40 carbon atoms, or a cycloalkyloxy group having 3 to 40 carbon atoms,
Ar3, Ar5, and Ar7 each independently represent an arylene group or a heteroarylene group,
Ar4, Ar6, and Ar8 each independently represent an aryl group or a heteroaryl group,
a to d represent the number of R5,
a represents an integer of 0 to 2,
b represents an integer of 0 to 3,
c represents an integer of 0 to 4, and
d represents an integer of 0 to 5.

Examples of the alkyl group, the alkyloxy group, the cycloalkyl group, the cycloalkyloxy group, the alkenyl group, and the aryloxy group that are represented by R5 of the general formulas (3a) to (3x) include the following groups:
alkyl groups (each having 1 to 8 carbon atoms) such as a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group;
alkyloxy groups (each having 1 to 8 carbon atoms) such as a methyloxy group, an ethyloxy group, an n-propyloxy group, an isopropyloxy group, an n-butyloxy group, a tert-butyloxy group, an n-pentyloxy group, an n-hexyloxy group, an n-heptyloxy group, and an n-octyloxy group;
cycloalkyl groups (each having 5 to 10 carbon atoms) such as a cyclopentyl group, a cyclohexyl group, a 1-adamantyl group, a 2-adamantyl group, and the like;
cycloalkyloxy groups (each having 5 to 10 carbon atoms) such as a cyclopentyloxy group, a cyclohexyloxy group, a cycloheptyloxy group, a cyclooctyloxy group, a 1-adamantyloxy group, and a 2-adamantyloxy group;
alkenyl groups (each having 2 to 6 carbon atoms) such as a vinyl group, an allyl group, an isopropenyl group, a 2-butenyl group, and the like; and
aryloxy groups such as a phenyloxy group and a tolyloxy group.

Examples of the alkyl group, the alkyloxy group, the cycloalkyl group, and the cycloalkyloxy group represented by R6 of the general formulas (3a) to (3x) may be the same groups as those listed for R5 above. It is most preferable that R6 represents an n-hexyl group or an n-octyl group from the viewpoint of enhancing the solubility.

Examples of the arylene group and the heteroarylene group represented by Ar3, Ar5, and Ar7 of the general formulas (3a) to (3x) include a phenylene group, a naphthylene group, an anthranilene group, a phenanthrenilene group, a fluorenylene group, an indenylene group, a pyrenylene group, a perylenylene group, a pyridinylene group, a pyrimidinylene group, a triazinylene group, a quinolinylene group, an isoquinolinylene group, a benzofuranylene group, a benzothiophenylene group, an indolylene group, a carbazolylene group, a benzoxazolylene group, a benzothiazolylene group, a quinoxalinylene group, a benzimidazolylene group, a pyrazolylene group, a dibenzofuranylene group, a dibenzothiophenylene group, a naphthyridinylene group, a phenanthrolinylene group, an acridinylene group, a carbolinylene group, and the like.

Examples of the aryl group and the heteroaryl group represented by Ar4, Ar6, and Ar8 of the general formulas (3a) to (3x) include a phenyl group, a naphthyl group, an anthracenyl group, a phenanthrenyl group, a triphenyl group, a fluorenyl group, an indenyl group, a pyrenyl group, a perylenyl group, a fluoranthenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, a naphthyridinyl group, a phenanthrolinyl group, an acridinyl group, a carbolinyl group, and the like.

### Thermally Crosslinkable Structural Unit

The high molecular weight compound may contain a repeating unit that has one or more thermally crosslinkable structural units selected from the group consisting of thermally crosslinkable structural units represented by general formula (4a) to (4z) given below. As used herein, the term "thermally crosslinkable structural unit" refers to a structural unit that forms a crosslinked structure through heating. 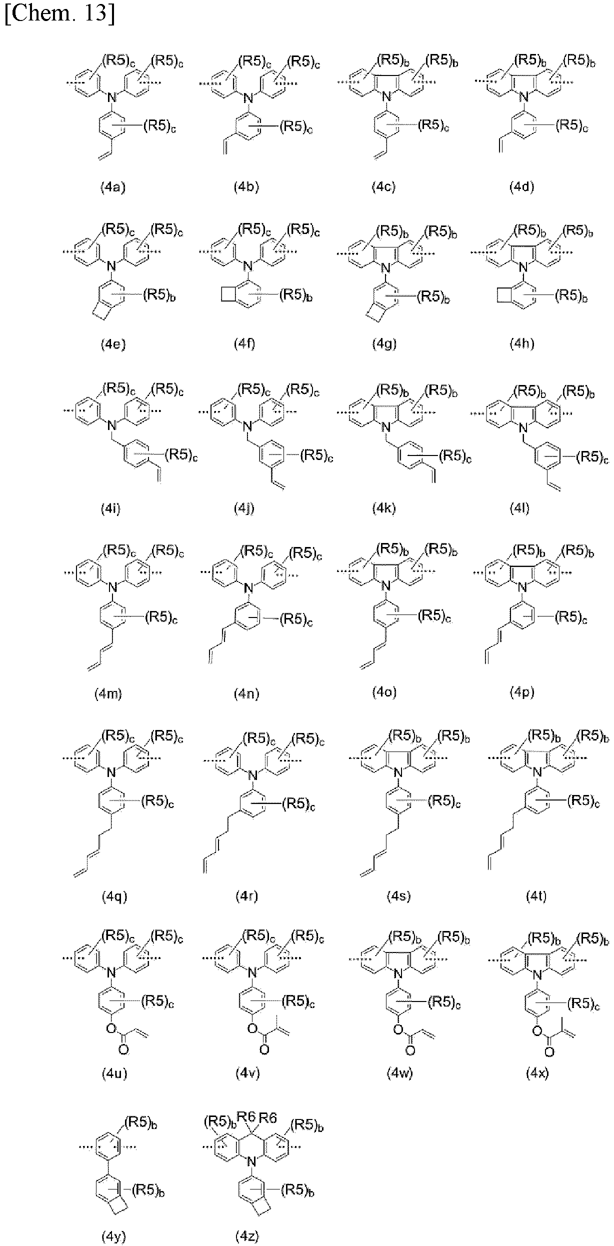 where R5, R6, a, b, and c represent the same as those of the general formulas (3a) to (3x) given above.

In the general formulas (4a) to (4z), it is most preferable that R6 represents an n-hexyl group or an n-octyl group from the viewpoint of enhancing the solubility.

### Triarylamine Structural Unit and Connecting Structural Unit

The high molecular weight compound may contain a repeating unit that has a triaryl structural unit represented by general formula (5) given below and a repeating unit that has a connecting structural unit represented by general formula (6) given below. The repeating unit may contain only either one or both of the structural units, but preferably contain both. 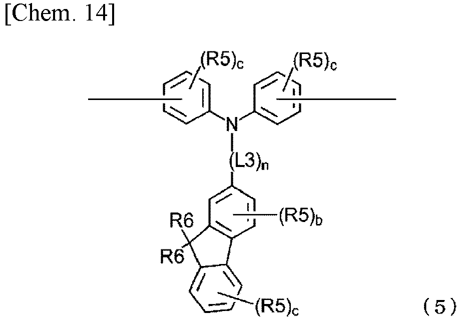 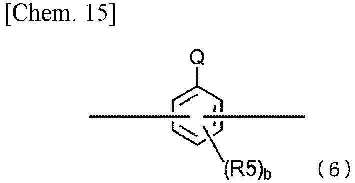
where R5, R6, b, and c represent the same as those of the general formulas (3 a) to (3x) given above,
Q represents a hydrogen atom, a heavy hydrogen atom, an amino group, an aryl group, or a heteroaryl group,
L3 represents a phenylene group, and
n represents an integer of 0 to 3.

In the general formulas (5) and (6), R5 preferably represents a hydrogen atom or a heavy hydrogen atom, and most preferably represents a hydrogen atom from the viewpoint of synthesis.

In the general formula (5), it is most preferable that R6 represents an n-hexyl group or an n-octyl group from the viewpoint of enhancing the solubility.

In the general formula (6), Q represents a hydrogen atom, a heavy hydrogen atom, an amino group, an aryl group, or a heteroaryl group.

Examples of the aryl group and the heteroaryl group include the following groups:
aryl groups such as a phenyl group, a naphthyl group, an anthracenyl group, a phenanthrenyl group, a fluorenyl group, an indenyl group, a pyrenyl group, a perylenyl group, and a fluoranthenyl group; and
heteroaryl groups such as a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, an indenocarbazolyl group, a benzoxazolyl group, a benzothiazolyl group, a quinoxalinyl group, a benzoimidazolyl group, a pyrazolyl group, a dibenzofuranyl group, a dibenzothienyl group, a naphthyridinyl group, a phenanthrolinyl group, an acridinyl group, and a carbolinyl group.

Also, the amino group, the aryl group, and the heteroaryl group described above may each contain a substituent. Examples of the substituents that may be contained in the above-described groups include a heavy hydrogen atom, a cyano group, a nitro group, and the like. Other examples include the following groups:
halogen atoms such as a fluorine atom, a chlorine atom, a bromine atom, and an iodine atom;
alkyl groups, specifically, an alkyl group having 1 to 8 carbon atoms, a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group;
alkyloxy groups, specifically, an alkyloxy group having 1 to 8 carbon atoms, a methyloxy group, an ethyloxy group, a propyloxy group, a phenyloxy group, and a tolyloxy group;
alkenyl groups such as a vinyl group and an allyl group;
aryl groups such as a phenyl group, a biphenyl group, a terphenyl group, a naphthyl group, an anthracenyl group, a phenanthrenyl group, a fluorenyl group, an indenyl group, a pyrenyl group, a perylenyl group, a fluoranthenyl group, and a triphenyl group;
heteroaryl groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, and a carbolinyl group;
arylvinyl groups such as a styryl group and a naphthylvinyl group; and
acyl groups such as an acetyl group and a benzoyl group.

Also, these substituents may further have any of the substituents listed above as examples. Furthermore, it is preferable that these substituents are each independently present, but these substituents may be bonded to each other to form a ring via a single bond, a methylene group that may contain a substituent, an oxygen atom, or a sulfur atom.

For example, the aryl group and the heteroaryl group may each contain a phenyl group as a substituent, and the phenyl group may further contain a phenyl group as a substituent. That is, in the case where the aryl group is, for example, a phenyl group, the aryl group may be a biphenylyl group, a terphenylyl group, or a triphenylenyl group.

In the general formula (5), L3 represents a phenylene group, and n represents an integer of 0 to 3.

Also, L3 may contain a substituent. Examples of the substituent that may be contained in L3 may be the same groups as those of the substituents that may be contained in Q described above, and these substituents may further contain a substituent.

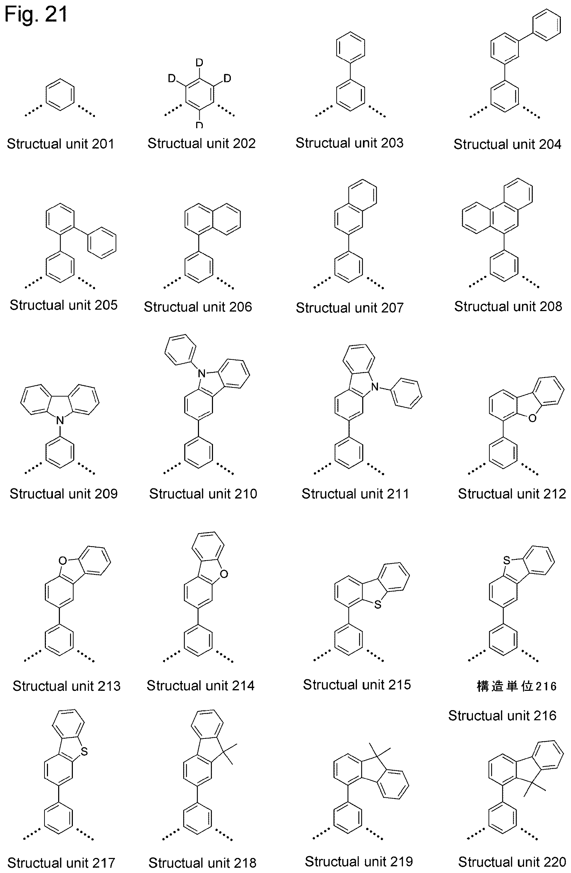

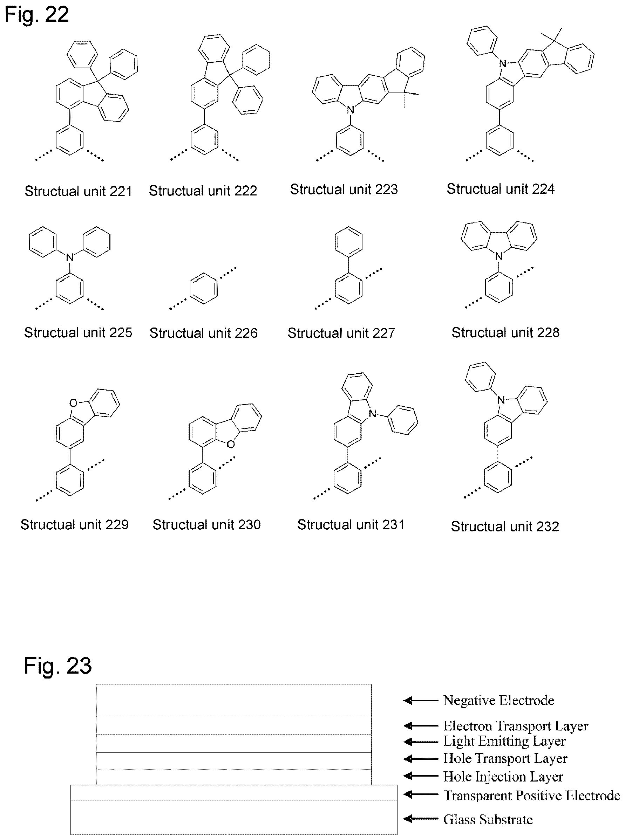

In the present invention, specific examples of the connecting structural unit represented by the general formula (6) given above are shown in Figs. 21 and 22 as structural units 201 to 232. In the chemical formulas shown in Figs. 21 and 22, a broken line indicates a bond to an adjacent structural unit. Preferred specific examples of connecting structural units are shown here, but examples of the connecting structural unit contained in the high molecular weight compound used in the present invention are not limited to these structural units.

The high molecular weight compound is preferably a copolymerized high molecular weight compound that contains a repeating unit represented by general formula (7) given below. 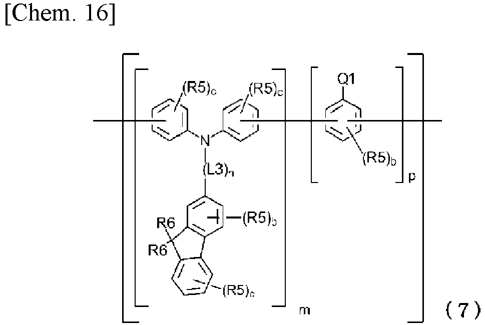
where R5, R6, b, and c represent the same as those of the general formulas (3 a) to (3x) given above,
Q1 represents a hydrogen atom, a heavy hydrogen atom, an amino group, an aryl group, or a heteroaryl group,
L3 represents a phenylene group,
n represents an integer of 0 to 3,
m represents a mole fraction of 0.1 to 0.9, and
p represents a mole fraction of 0.1 to 0.9.

In the general formula (7), m and p each represent a mole fraction in the repeating unit. m preferably represents 0.2 to 0.8, and p preferably represents 0.3 to 0.7.

In the general formula (7), examples of the aryl group and the heteroaryl group represented by Q1 may be the same as those represented by Q of the general formula (6).

### Preferred Structural Unit

The high molecular weight compound preferably contains a repeating unit that has a structural unit represented by the general formula (2) given above and a structural unit represented by the general formula (3a) given above, and more preferably also contains a repeating unit that has a structural unit represented by the general formula (3a) given above and a structural unit represented by the general formula (4e) given above. Also, the high molecular weight compound preferably also contains a repeating unit represented by the general formula (7) given above, and more preferably also contains a repeating unit that that has a structural unit represented by the general formula (6) given above and a structural unit represented by the general formula (4e) given above.

### Weight-Average Molecular Weight

The high molecular weight compound has a weight-average molecular weight in terms of polystyrene measured using GPC of preferably 10,000 or more and less than 1,000,000, more preferably 10,000 or more and less than 500,000, and even more preferably 10,000 or more and less than 200,000.

### Synthesis Method

The high molecular weight compound is synthesized by forming a C-C bond or a C-N bond to connect structural units through a Suzuki polymerization reaction or a HARTWIG-BUCHWALD polymerization reaction. Specifically, the high molecular weight compound can be synthesized by preparing unit compounds each having a structural unit, borate esterifying or halogenating the unit compounds as appropriate, and performing a polycondensation reaction using a catalyst.

For example, as a compound for introducing a structural unit represented by the general formula (2), a triarylamine derivative represented by general formula (2a) given below can be used. 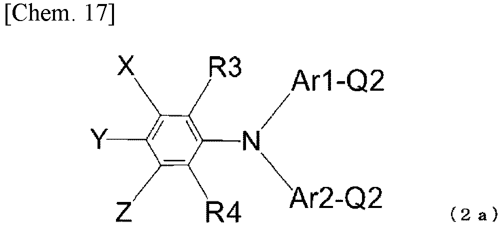 where Q2 represents a hydrogen atom or a halogen atom (specifically Br), and Ar1, Ar2, X, Y, and Z, as well as R3 and R4 represent the same as those of the general formula (2) given above.

A compound represented by the general formula (2a), where Q2 represents a hydrogen atom is a unit compound for introducing a triarylamine structural unit represented by the general formula (2), and a compound represented by the general formula (2a), where Q2 represents a halogen atom is a halide used to synthesize a polymer.

For example, a terpolymer that contains 40 mol% of a structural unit represented by the general formula (2) (structural unit A), 50 mol% of a structural unit represented by the general formula (3a) (structural unit B), and 10 mol% of a structural unit represented by the general formula (4e) (structural unit C) is represented by general formula (8) given below. That is, the terpolymer is a copolymer that contains 80 mol% of a repeating unit that is composed of the structural unit A and the structural unit B and 20 mol% of a repeating unit that is composed of the structural unit C and the structural unit B.

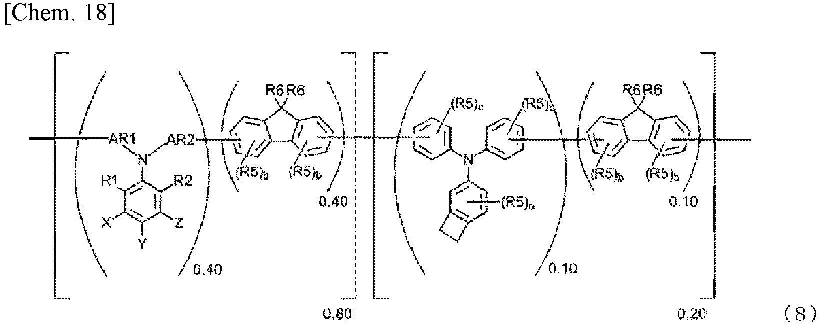

In the case where intermediate products for introducing the structural unit A and the structural unit C are halogenated products, an intermediate product for introducing the structural unit B is a borate esterified product. Alternatively, in the case where the intermediate products for introducing the structural unit A and the structural unit C are borate esterified products, the intermediate product for introducing the structural unit B is a halogenated product. That is, the molar ratio between the halogenated product and the borate esterified product must be equal.

Also, for example, a terpolymer that contains 40 mol% of a structural unit represented by the general formula (5) (structural unit D), 50 mol% of a structural unit represented by the general formula (6) (structural unit E), and 10 mol% of a structural unit represented by the general formula (4e) (structural unit C) is represented by general formula (9) given below. That is, the terpolymer is a copolymer that contains 80 mol% of a repeating unit that is composed of the structural unit D and the structural unit E and 20 mol% of a repeating unit that is composed of the structural unit C and the structural unit E.

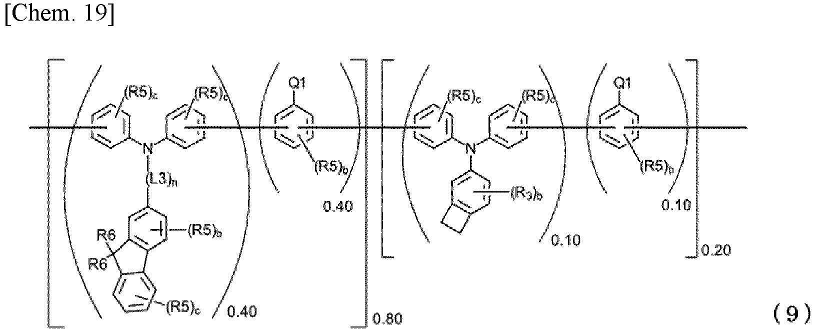

In the case where intermediate products for introducing the structural unit D and the structural unit C are borate esterified products, an intermediate product for introducing the structural unit E is a halogenated product. Alternatively, in the case where the intermediate products for introducing the structural unit D and the structural unit C are halogenated products, the intermediate product for introducing the structural unit E is a borate esterified product. That is, the molar ratio between the halogenated product and the borate esterified product must be equal.

### Solvent

The composition for light emitting diodes according to the present invention may contain a solvent. As the solvent, an aromatic organic solvent such as benzene, toluene, xylene, or anisole, or the like can be used.

### Film Forming Method

The composition for light emitting diodes is dissolved in an aromatic organic solvent such as, for example, benzene, toluene, xylene, or anisole to prepare a coating solution mixture. The coating solution mixture is applied to a predetermined substrate to form a coating on the substrate, and the substrate is heated and dried to form a thin film with excellent characteristics including hole injection performance, hole transport performance, and electron blocking performance. The thin film obtained in the above-described manner also has good heat resistance, as well as good adhesion to other layers.

### Organic Layer

The composition for light emitting diodes can be used as a constituent material of a hole injection layer and/or a hole transport layer in an organic EL element. With the hole injection layer and the hole transport layer formed using the composition for light emitting diodes, it is possible to achieve an advantageous effect that the durability of the organic EL element can be improved as compared with conventional organic EL elements produced using a high molecular weight compound alone. In addition, the composition for light emitting diodes is also suitable for use in forming an electron blocking layer or a light emitting layer.

### Preferred Application of Composition for Light Emitting Diodes

It is preferable that the composition for light emitting diodes according to the present invention is used particularly as a composition for organic electroluminescent elements. As used herein, the term "composition for organic electroluminescent elements" refers to a composition that can form an organic layer for an organic electroluminescent element.

### Organic EL Element

An organic electroluminescent element of the present invention that includes an organic layer formed using the composition for light emitting diodes described above has, for example, a structure shown in Fig. 23. Specifically, a transparent positive electrode 2, a hole injection layer 3, a hole transport layer 4, a light emitting layer 5, an electron transport layer 6, and a negative electrode 7 are provided on a glass substrate 1. The glass substrate 1 may be replaced by another transparent substrate such as a transparent resin substrate.

The structure of the organic EL element is not limited to the layer structure described above. A hole blocking layer may be provided between the light emitting layer 5 and the electron transport layer 6. Also, an electron blocking layer and the like may be provided between the hole transport layer 4 and the light emitting layer 5. Furthermore, an electron injection layer may also be provided between the negative electrode 7 and the electron transport layer 6. Furthermore, some of the layers may be omitted. For example, the organic EL element may have a simple layer structure in which a positive electrode 2, a hole transport layer 4, a light emitting layer 5, an electron transport layer 6, and a negative electrode 7 are provided on a substrate 1. Also, the organic EL element may also have a two-layer structure in which layers that have the same function are superimposed on each other.

The composition for light emitting diodes is suitable for use in forming, for example, the hole injection layer 3, the hole transport layer 4, the light emitting layer 5, and the electron blocking layer (not shown in the diagrams), as the organic layers provided between the positive electrode 2 and the negative electrode 7 by utilizing the characteristics of the composition for light emitting diodes such as hole injection performance and hole transport performance.

In the organic EL element, the transparent positive electrode 2 may be formed using a known electrode material, and is formed by depositing an electrode material that has a large work function such as ITO or gold on a transparent substrate such as a glass substrate.

Also, the hole injection layer 3 provided on the transparent positive electrode 2 can be formed using a coating solution prepared by dissolving the composition for light emitting diodes in an aromatic organic solvent such as, for example, toluene, xylene, or anisole. The hole injection layer 3 can be formed by, for example, applying the coating solution onto the transparent positive electrode 2 to form a coating on the transparent positive electrode 2 through spin coating or inkjet printing, or the like.

Alternatively, the hole injection layer 3 may also be formed using a conventionally known material such as, for example, any of the following materials, without using the high molecular weight compound:
porphyrin compounds as typified by copper phthalocyanine;
starburst triphenylamine derivatives;
arylamines that each have a structure in which connection is implemented using a single bond or an arylene group that does not contain a hetero atom (for example, triphenylamine trimer and triphenylamine tetramer);
acceptor heterocycle compounds such as hexacyanoazatriphenylene; and
application-type high molecular weight materials such as, for example, poly(3,4-ethylene dioxythiophene) (PEDOT) and poly(styrene sulfonate) (PSS).

A layer (thin film) can be formed using any of the materials listed above based on a coating method such as a deposition method, a spin coating method, or an inkjet method. The same applies to other layers, and a deposition method or a coating method is used according to the type of film forming material.

The hole transport layer 4 provided on the hole injection layer 3 can also be formed using a coating solution in which the composition for light emitting diodes is dissolved, based on a coating method such as a spin coating method or an inkjet method, as with the hole injection layer 3.

Alternatively, the hole transport layer 4 may also be formed using a conventionally known hole transport material. Typical examples of the hole transport material are as follows:
benzidine derivatives such as, for example, N,N'-diphenyl-N,N'-di(m-tolyl)benzidine (hereinafter referred to simply as "TPD", N,N'-diphenyl-N,N'-di(α-naphthyl)benzidine (hereinafter referred to simply as "NPD"), and N,N,N',N'-tetrabiphenylyl benzidine;
amine-based derivatives such as, for example, 1,1-bis[4-(di-4-tolylamino)phenyl]cyclohexane (hereinafter referred to simply as "TAPC");
various types of triphenylamine trimers and tetramers; and
application-type high molecular weight materials that are also used to form hole injection layers.

The compounds for forming a hole transport layer described above, including the high molecular weight compound, may be used alone or in a combination of two or more. It is also possible to form a plurality of layers using one or more of the compounds listed above, and use the resulting multilayer film in which the plurality of layers are stacked as the hole transport layer.

It is also possible to form a layer that functions as both the hole injection layer 3 and the hole transport layer 4. Such a hole injection/transport layer can be formed using a high molecular weight material such as PEDOT based on a coating method.

In the hole transport layer 4 (the same applies to the hole injection layer 3), it is possible to use a material obtained by p-doping a material normally used to form a hole transport layer with trisbromophenylamine hexachlor antimony, a radialene derivative (see, for example, WO 2014/009310), or the like. Also, the hole transport layer 4 (or the hole injection layer 3) can be formed using a high molecular weight compound that has a TPD backbone, or the like.

An electron blocking layer (not shown in the diagrams) (that may be provided between the hole transport layer 4 and the light emitting layer 5) can also be formed using a coating solution in which the composition for light emitting diodes is dissolved, based on a coating method such as a spin coating method or an inkjet method, as with the hole transport layer 4.

Also, the electron blocking layer may also be formed using a known electron blocking compound that has an electron blocking effect such as, for example, a carbazole derivative or a compound that has a triphenylsilyl group and a triarylamine structure. Specific examples of the carbazole derivative and the compound that has a triarylamine structure include:
carbazole derivatives such as, for example, 4,4',4"-tri(N-carbazolyl)triphenylamine (hereinafter referred to simply as "TCTA"), 9,9-bis[4-(carbazole 9-yl)phenyl]fluorene, 1,3-bis(carbazole 9-yl)benzene (hereinafter referred to simply as "mCP"), 2,2-bis[4-(carbazole 9-yl)phenyl]adamantane (hereinafter referred to simply as "Ad-Cz"); and
compounds that have a triarylamine structure such as, for example, 9-[4-(carbazole 9-yl)phenyl]-9-[4-(triphenylsilyl)phenyl]-9H-fluorene.

The known electron blocking materials listed above may be used alone or in a combination of two or more to form an electron blocking layer. However, it is also possible to form a plurality of layers using one or more of the electron blocking materials, and use the resulting multilayer film in which the plurality of layers are stacked as an electron blocking layer.

The light emitting layer 5 of the organic EL element may be formed using a metal complex of quinolinol derivative such as Alq₃. Other examples include: various types of metal complexes of zinc, beryllium, aluminum, and the like; and light emitting materials such as an anthracene derivative, a bisstyryl benzene derivative, a pyrene derivative, an oxazole derivative, and a polyparaphenylene vinylene derivative.

Also, the light emitting layer 5 may also be formed using a host material and a dopant material.

In this case, as the host material, in addition to the light emitting materials described above, a thiazole derivative, a benzimidazole derivative, a polydialkyl fluorene derivative, and the like can be used. Furthermore, the high molecular weight compounds described above may also be used alone or in a combination. As the dopant material, quinacridone, coumalin, rubrene, perylene, derivatives thereof, a benzopyran derivative, a rhodamine derivative, an aminostyryl derivative, and the like can be used.

The light emitting layer 5 described above may also have a monolayer structure using one or two or more of the light emitting materials, or a multilayer structure in which a plurality of layers are stacked.

Furthermore, the light emitting layer 5 may also be formed using a phosphorescent light emitting material as the light emitting material.

As the phosphorescent light emitting material, a phosphorescent emitter made of a metal complex of iridium, platinum, or the like can be used. For example, a green phosphorescent emitter such as Ir(ppy)₃, a blue phosphorescent emitter such as FIrpic or FIr6, a red phosphorescent emitter such as Btp₂Ir (acac), or the like can be used. Each of these phosphorescent light emitting materials is used by being doped into a host material that has hole injection/transport performance or a host material that has electron transport performance.

As the host material that has hole injection/transport performance, carbazole derivatives such as 4,4'-di(N-carbazolyl)biphenyl (hereinafter referred to simply as "CBP"), TCTA, and mCP, and the like can be used. Furthermore, the high molecular weight compounds described above may also be used.

As the host material that has electron transport performance, p-bis(triphenylsilyl)benzene (hereinafter referred to simply as "UGH2), 2,2',2"-(1,3,5-phenylene)-tris(1-phenyl-1H-benzimidazole) (hereinafter referred to simply as "TPBI"), and the like can be used.

In order to avoid concentration quenching, when doping a phosphorescent light emitting material into a host material, it is preferable to perform doping using co-deposition within a range of 1 to 30 weight percent relative to the entire light emitting layer.

Also, as the light emitting material, it is also possible to use materials that emit delayed fluorescence such as CDCB derivatives including PIC-TRZ, CC2TA, PXZ-TRZ, and 4CzIPN (see Appl. Phys. Let., 98,083302 (2011)).

By forming the light emitting layer 5 by causing the high molecular weight compound to carry a fluorescent emitter, a phosphorescent emitter, or a material that emits delayed fluorescence called as a dopant, it is possible to implement an organic EL element that has a low driving voltage and improved light emission efficiency.

The hole blocking layer (not shown in the diagrams) provided between the light emitting layer 5 and the electron transport layer 6 can be formed using a known hole blocking compound.

Examples of the known hole blocking compound include: phenanthroline derivatives such as bathocuproine (hereinafter referred to simply as "BCP"); metal complexes of quinolinol derivative such as aluminum(III)bis(2-methyl-8-quinolinate)-4-phenylphenolate (hereinafter referred to simply as "BAlq"); various types of rare earth complexes; triazole derivatives; triazine derivatives; and oxadiazole derivatives.

These materials may also be used to form the electron transport layer 6, which will be described below, and also be used as the hole blocking layer and the electron transport layer 6.

The hole blocking layer described above may also have a monolayer structure or a multilayer structure, with each layer being formed using one or two or more of the hole blocking compounds.

The electron transport layer 6 is formed using a known electron transport compound such as, for example, a metal complex of quinolinol derivative such as Alq₃ or BAlq. Other examples of the known electron transport compound include: various types of metal complexes; pyridine derivatives; pyrimidine derivatives; triazole derivatives; triazine derivatives; oxadiazole derivatives; thiadiazole derivatives; carbodiimide derivatives; quinoxaline derivatives; phenanthroline derivatives; silole derivatives; benzoimidazole derivatives; and the like.

The electron transport layer 6 may also have a monolayer structure or a multilayer structure, with each layer being formed using one or two or more of the electron transport compounds.

Furthermore, the electron injection layer (not shown in the diagrams) that is provided optionally can also be formed using a known material. Examples of the known material include: alkali metal salts such as lithium fluoride and cesium fluoride; alkaline earth metal salts such as magnesium fluoride; metal oxides such as aluminum oxide; and organic metal complexes such as lithium quinoline.

The negative electrode 7 of the organic EL element is formed using an electrode material that has a low work function such as aluminum. Alternatively, an alloy that has a lower work function such as a magnesium silver alloy, a magnesium indium alloy, or an aluminum magnesium alloy may also be used as the electrode material of the negative electrode 7.

In the present invention, the composition for light emitting diodes is used to form at least any one of the hole injection layer 3, the hole transport layer 4, the light emitting layer 5, and the electron blocking layer (not shown in the diagrams), and it is thereby possible to obtain an organic EL element that has a high light emission efficiency, a high power efficiency, a low practical driving voltage, and very good durability. In particular, an organic EL element whose hole transport layer 4 is formed using the composition for light emitting diodes has a low driving voltage, improved current resistance, and improved maximum emission intensity while having a high light emission efficiency.

### Examples

Hereinafter, the present invention will be described based on the following experimental examples.

Details of the synthesis method for producing a high molecular weight compound that has a structural unit represented by the general formula (2) used in the present invention can be found in WO 2018/168667.

### Example 1

### Synthesis of High Molecular Weight Compound I

The following components were placed in a nitrogen-substituted reaction vessel, and nitrogen gas was passed through the reaction vessel for 30 minutes.
2,7-Bis(4,4,5,5-tetramethyl-1,3,2-dioxaborolane-2-yl)-9,9-di-n-octyl fluorene: 6.5 g
N,N-Bis(4-bromophenyl)-4-(2-naphthalenyl)-[1,1':2',1"-terphenyl]-4'-amine: 5.5 g
N,N-Bis(4-bromophenyl)-bicyclo[4.2.0]octa-1,3,5-triene-3-amine: 0.87 g
Tripotassium phosphate: 9.0 g
Toluene: 16 ml
Water: 9 ml
1,4-Dioxane: 48 ml

Next, 1.9 mg of palladium (II) acetate and 15.0 mg of tri-o-tolylphosphine were added, and the reaction vessel was heated and stirred at 88°C for 10 hours. After that, 22 mg of phenylboronic acid was added, and the reaction vessel was stirred for 1 hour. Next, 0.32 g of bromobenzene was added, and the reaction vessel was stirred for 1 hour. 100 ml of toluene and 100 ml of an aqueous solution of 5 wt% N,N-sodium diethyldithiocarbamate were added, and the reaction vessel was heated and stirred under reflux for 2 hours. Next, the reaction vessel was cooled to room temperature, and then, saturated saline water and toluene were added, and a separation operation was performed to obtain an organic layer. The obtained organic layer was dehydrated using anhydrous magnesium sulfate, and then concentrated under reduced pressure to obtain a crude polymer. The crude polymer was dissolved in toluene, a silica gel was added, and adsorption purification and filtration were performed to remove the silica gel. The obtained filtrate was concentrated under reduced pressure, and 300 ml of toluene was added to a dried solid to dissolve the dried solid. The obtained solution was added dropwise to 600 ml of n-hexane, and the obtained precipitate was filtered. This operation was repeated three times, followed by drying to obtain 8.3 g of a high molecular weight compound I (with a yield of 93%).

The average molecular weight and the dispersity of the high molecular weight compound I measured using GPC were as follows.
Number average molecular weight Mn (in terms of polystyrene): 55,000
Weight-average molecular weight Mw (in terms of polystyrene): 120,000
Dispersity (Mw/Mn): 2.2

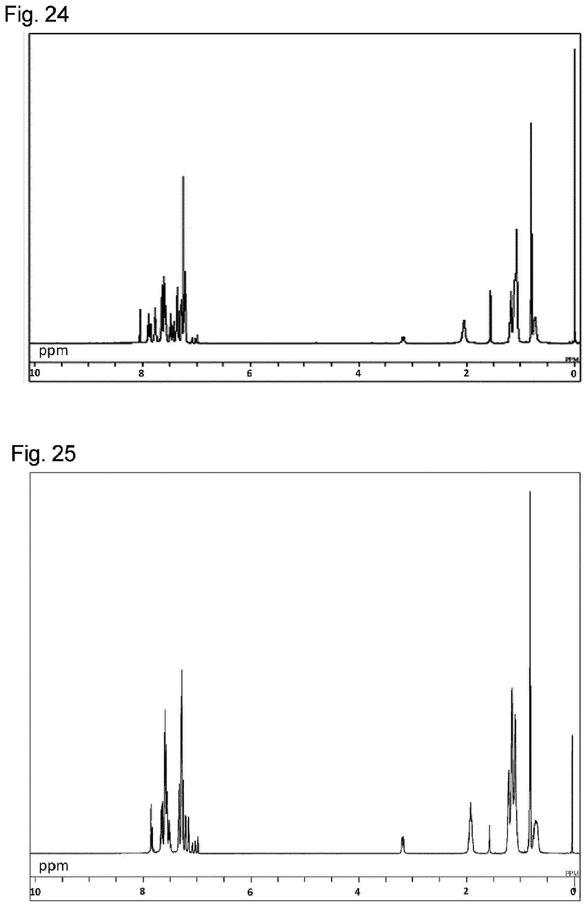

Also, NMR measurement was performed on the high molecular weight compound I. ¹H-NMR measurement results are shown in Fig. 24. The following chemical composition formula was used.

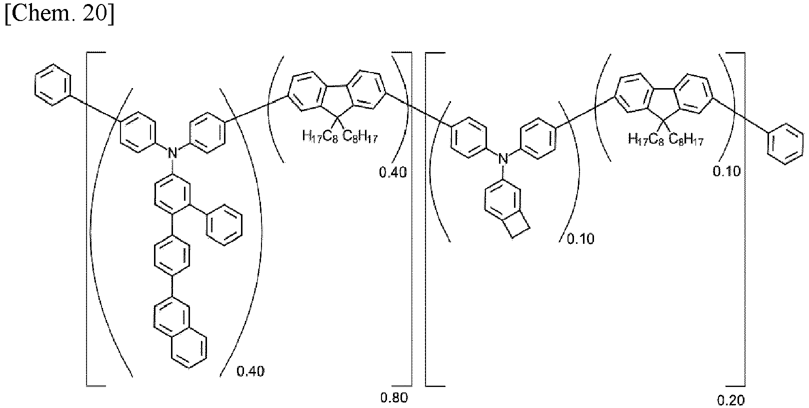

### High molecular weight compound I

As can be understood from the chemical composition given above, the high molecular weight compound I contained 40 mol% of the structural unit A represented by the general formula (2), 50 mol% of the structural unit B represented by the general formula (3a), and 10 mol% of the structural unit C represented by the general formula (4e).

### Example 2

### Synthesis of High Molecular Weight Compound II

The following components were placed in a nitrogen-substituted reaction vessel, and nitrogen gas was passed through the reaction vessel for 30 minutes.
9,9-Dioctyl-N,N-bis[4-(4,4,5,5-tetramethyl-1,3,2-dioxaborolane-2-yl)phenyl]-9H-fluorene-2-amine: 5.0 g
1,3-Dibromobenzene: 1.8 g
N,N-Bis[4-(4,4,5,5-tetramethyl-1,3,2-dioxaborolane-2-yl)phenyl] bicyclo[4.2.0]octa-1,3,5-triene-3-amine: 0.8 g
Tripotassium phosphate: 6.9 g
Toluene: 9 ml
Water: 5 ml
1,4-Dioxane: 27 ml

Next, 1.4 mg of palladium (II) acetate and 11.5 mg of tri-o-tolylphosphine were added, and the reaction vessel was heated and stirred at 87°C for 14 hours. After that, 17 mg of phenylboronic acid was added, and the reaction vessel was stirred for 1 hour. Next, 242 mg of bromobenzene was added, and the reaction vessel was stirred for 1 hour. 50 ml of toluene and 50 ml of an aqueous solution of 5 wt%N,N-sodium diethyldithiocarbamate were added, and the reaction vessel was heated and stirred under reflux for 2 hours. The reaction vessel was cooled to room temperature, and then, a separation operation was performed to obtain an organic layer, and the obtained organic layer was washed with saturated saline water three times. The organic layer was dehydrated using anhydrous magnesium sulfate, and then concentrated under reduced pressure to obtain a crude polymer. The crude polymer was dissolved in toluene, a silica gel was added, and adsorption purification and filtration were performed to remove the silica gel. The obtained filtrate was concentrated under reduced pressure, and 100 ml of toluene was added to a dried solid to dissolve the dried solid. The obtained solution was added dropwise to 300 ml of n-hexane, and the obtained precipitate was filtered. This operation was repeated three times, followed by drying to obtain 3.5 g of a high molecular weight compound II (with a yield of 78%).

The average molecular weight and the dispersity of the high molecular weight compound II measured using GPC were as follows.
Number average molecular weight Mn (in terms of polystyrene): 32,000
Weight-average molecular weight Mw (in terms of polystyrene): 55,000
Dispersity (Mw/Mn): 1.7

Also, NMR measurement was performed on the high molecular weight compound II. ¹H-NMR measurement results are shown in Fig. 25. The following chemical composition formula was used.

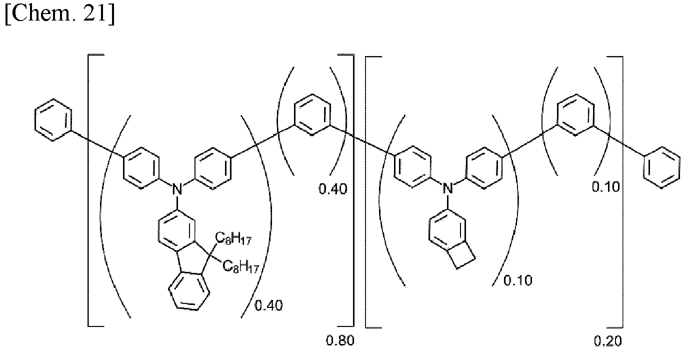

### High molecular weight compound II

As can be understood from the chemical composition given above, the high molecular weight compound II contained 40 mol% of the structural unit D represented by the general formula (5), 50 mol% of the structural unit E represented by the general formula (6), and 10 mol% of the structural unit C represented by the general formula (4e).

### Example 3

### Production and Evaluation of Organic EL Element

An organic EL element with a layer structure shown in Fig. 23 was produced using the following method.

A glass substrate 1 with a 50 nm-thick ITO layer formed thereon was washed with an organic solvent, and then, UV/ozone treatment was performed to wash the surface of the ITO layer. A PEDOT/PSS solution (available from HERAEUS) was applied to cover the transparent positive electrode 2 (ITO layer) formed on the glass substrate 1 using a spin coating method to form a film with a thickness of 50 nm, and the substrate was dried on a hot plate at 200°C for 10 minutes to form a hole injection layer 3.

A coating solution was prepared by mixing the high molecular weight compound I obtained in Example 1 with compound 1 serving as a thermally crosslinkable low molecular weight compound in a physical quantity 2.5 times the physical quantity of the structural unit C contained in the high molecular weight compound I, and dissolving the resulting mixture in toluene at a concentration of 0.6 weight%. The substrate on which the hole injection layer 3 was formed in the manner described above was transferred in a dry nitrogen-substituted glove box, and dried on a hot plate at 230°C for 10 minutes. After that, the above coating solution was applied onto the hole injection layer 3 by spin coating to form an application layer with a thickness of 25 nm, and the substrate was dried on a hot plate at 220°C for 30 minutes to form a hole transport layer 4.

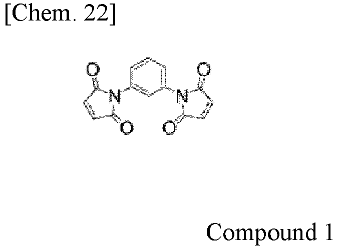

The substrate on which the hole transport layer 4 was formed in the manner described above was placed in a vacuum deposition machine, and the pressure was reduced to 0.001 Pa or less. Using a blue light emitting material (ENM-1) and a host material (EMH-1) with the following structural formulas, double deposition was performed on the hole transport layer 4 to form a light emitting layer 5 with a thickness of 34 nm. In the double deposition, the deposition speed ratio was set to EMD-1 : EMH-1 = 4:96.

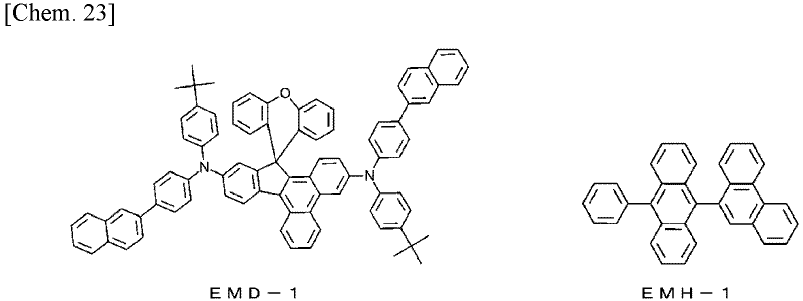

Using electron transport materials (ETM-1) and (ETM-2) with the following structural formulas, double deposition was performed on the light emitting layer 5 formed in the above-described manner to form an electron transport layer 6 with a thickness of 20 nm. In the double deposition, the deposition speed ratio was set to ETM-1 : ETM-2 = 50:50.

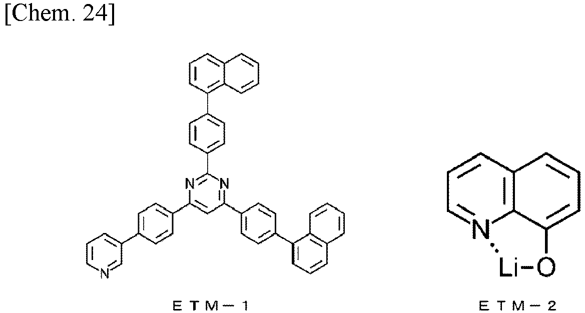

Finally, a negative electrode 7 was formed by depositing aluminum on the electron transport layer 6 formed in the above-described manner to have a thickness of 100 nm.

The thus-produced glass substrate including the transparent positive electrode 2, the hole injection layer 3, the hole transport layer 4, the light emitting layer 5, the electron transport layer 6, and the negative electrode 7 was transferred in a dry nitrogen-substituted glove box. After that, the glass substrate was bonded to a glass substrate for sealing using a UV curable resin to obtain an organic EL element. The produced organic EL element was subjected to characteristics measurement in the atmosphere at room temperature. Also, light emission characteristics when a direct current voltage was applied to the produced organic EL element were measured.

The results of the above measurement are shown in Table 1.

### Example 4

An organic EL element was produced in the same manner as in Example 3, except that a hole transport layer 4 was formed by heating and drying a coating layer for forming the hole transport layer 4 on a hot plate at 220°C for 30 minutes. The produced organic EL element was evaluated for various characteristics, and the results are shown in Table 1.

### Example 5

An organic EL element was produced in the same manner as in Example 3, except that a hole transport layer 4 was formed using a coating solution prepared by mixing the high molecular weight compound II obtained in Example 2, instead of the high molecular weight compound I, with compound 1 serving as a thermally crosslinkable low molecular weight compound in a quantity equal to the physical quantity of the structural unit C contained in the high molecular weight compound II, and dissolving the resulting mixture in toluene at a concentration of 0.6 weight%. The produced organic EL element was evaluated for various characteristics, and the results are shown in Table 1.

### Example 6

An organic EL element was produced in the same manner as in Example 3, except that a hole transport layer 4 was formed by applying, to a substrate, a coating solution prepared by mixing the high molecular weight compound II, instead of the high molecular weight compound I, with compound 1 serving as a thermally crosslinkable low molecular weight compound in a quantity equal to the physical quantity of the structural unit C contained in the high molecular weight compound II, and dissolving the resulting mixture in toluene at a concentration of 0.6 weight%, and heating and drying the substrate on a hot plate at 220°C for 30 minutes. The produced organic EL element was evaluated for various characteristics, and the results are shown in Table 1.

### Example 7

An organic EL element was produced in the same manner as in Example 3, except that a hole transport layer 4 was formed by applying, to a substrate, a coating solution prepared by mixing the high molecular weight compound II, instead of the high molecular weight compound I, with compound 3 serving as a thermally crosslinkable low molecular weight compound in a quantity equal to the physical quantity of the structural unit C contained in the high molecular weight compound II, and dissolving the resulting mixture in toluene at a concentration of 0.6 weight%, and heating and drying the substrate on a hot plate at 220°C for 30 minutes. The produced organic EL element was evaluated for various characteristics, and the results are shown in Table 1.

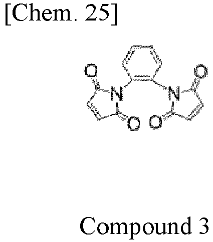

### Example 8

An organic EL element was produced in the same manner as in Example 3, except that a hole transport layer 4 was formed by applying, to a substrate, a coating solution prepared by mixing the high molecular weight compound II, instead of the high molecular weight compound I, with compound 26 serving as a thermally crosslinkable low molecular weight compound in a quantity equal to the physical quantity of the structural unit C contained in the high molecular weight compound II, and dissolving the resulting mixture in toluene at a concentration of 0.6 weight%, and heating and drying the substrate on a hot plate at 220°C for 30 minutes. The produced organic EL element was evaluated for various characteristics, and the results are shown in Table 1.

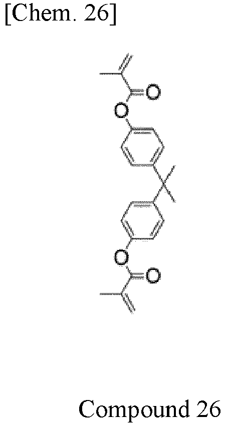

### Example 9

An organic EL element was produced in the same manner as in Example 3, except that a hole transport layer 4 was formed using a coating solution prepared by mixing a mixture of the high molecular weight compound I and the high molecular weight compound II mixed at a weight ratio of 3:2, instead of the high molecular weight compound I, with compound 1 serving as a thermally crosslinkable low molecular weight compound in a quantity equal to the physical quantity of the structural unit C contained in the high molecular weight compound I and the high molecular weight compound II, and dissolving the resulting mixture in toluene at a concentration of 0.6 weight%. The produced organic EL element was evaluated for various characteristics, and the results are shown in Table 1.

### Example 10

An organic EL element was produced in the same manner as in Example 3, except that a hole transport layer 4 was formed by applying, to a substrate, a coating solution prepared by mixing a mixture of the high molecular weight compound I and the high molecular weight compound II mixed at a weight ratio of 3:2, instead of the high molecular weight compound I, with compound 1 serving as a thermally crosslinkable low molecular weight compound in a quantity equal to the physical quantity of the structural unit C contained in the high molecular weight compound I and the high molecular weight compound II, and dissolving the resulting mixture in toluene at a concentration of 0.6 weight%, and drying the substrate on a hot plate at 220°C for 30 minutes. The produced organic EL element was evaluated for various characteristics, and the results are shown in Table 1.

### Comparative Example 1

An organic EL element was produced in the same manner as in Example 3, except that a hole transport layer 4 was formed using a coating solution prepared by dissolving only the high molecular weight compound I in toluene at a concentration of 0.6 weight%, without adding a thermally crosslinkable low molecular weight compound. The produced organic EL element was evaluated for various characteristics, and the results are shown in Table 1.

### Comparative Example 2

An organic EL element was produced in the same manner as in Example 3, except that a hole transport layer 4 was formed by applying, to a substrate, a coating solution prepared by dissolving only the high molecular weight compound I in toluene at a concentration of 0.6 weight%, without adding a thermally crosslinkable low molecular weight compound, and drying the substrate on a hot plate at 220°C for 30 minutes. The produced organic EL element was evaluated for various characteristics, and the results are shown in Table 1.

### Comparative Example 3

An organic EL element was produced in the same manner as in Example 3, except that a hole transport layer 4 was formed using a coating solution prepared by dissolving only the high molecular weight compound II, instead of the high molecular weight compound I, in toluene at a concentration of 0.6 weight%, without adding a thermally crosslinkable low molecular weight compound. The produced organic EL element was evaluated for various characteristics, and the results are shown in Table 1.

### Comparative Example 4

An organic EL element was produced in the same manner as in Example 3, except that a hole transport layer 4 was formed by applying, to a substrate, a coating solution prepared by dissolving only the high molecular weight compound II, instead of the high molecular weight compound I, in toluene at a concentration of 0.6 weight%, without adding a thermally crosslinkable low molecular weight compound, and drying the substrate on a hot plate at 220°C for 30 minutes. The produced organic EL element was evaluated for various characteristics, and the results are shown in Table 1.

### Comparative Example 5

An organic EL element was produced in the same manner as in Example 3, except that a hole transport layer 4 was formed using a coating solution prepared by dissolving, in toluene, a mixture of the high molecular weight compound I and the high molecular weight compound II mixed at a weight ratio of 3:2, instead of the high molecular weight compound I, at a concentration of 0.6 weight%, without adding a thermally crosslinkable low molecular weight compound. The produced organic EL element was evaluated for various characteristics, and the results are shown in Table 1.

### Comparative Example 6

An organic EL element was produced in the same manner as in Example 3, except that a hole transport layer 4 was formed by applying, to a substrate, a coating solution prepared by dissolving, in toluene, a mixture of the high molecular weight compound I and the high molecular weight compound II mixed at a weight ratio of 3:2, instead of the high molecular weight compound I, at a concentration of 0.6 weight%, without adding a thermally crosslinkable low molecular weight compound, and drying the substrate on a hot plate at 220°C for 30 minutes. The produced organic EL element was evaluated for various characteristics, and the results are shown in Table 1.

In the evaluation of various characteristics, the term "element service time" refers to the time required until the emission intensity is attenuated to 560 cd/m² (corresponding to 80% when the initial intensity is set to 100%: an attenuation of 80%) when constant current driving is performed, with the emission intensity (initial intensity) at the start of light emission being set to 700 cd/m².

**[Table 1]**

| | Hole transport | layer 4 | Heating condition | Voltage [V] | Emission intensity [cd/m²] | Light emission efficiency [cd/A] | Power efficiency [Im/W] | Element service time [h] |
|---|---|---|---|---|---|---|---|---|
| | High molecular weight compound | Thermally crosslinkable low molecular weight compound | | | | | | |
| Example 3 | High molecular weight compound I | Compound 1 | At 200C° for 10 min | 3.92 | 886 | 8.86 | 7.10 | 280 |
| Example 4 | | | At 220C° for 30 min | 4.02 | 887 | 8.87 | 6.94 | 36 |
| Example 5 | High molecular weight compound II | Compound 1 | At 200C° for 10 mm | 3.99 | 895 | 8.95 | 7.05 | 451 |
| Example 6 | | | At 220C° for 30 mm | 4.21 | 1022 | 10.22 | 7.64 | 64 |
| Example 7 | | Compound 3 | At 220C° for 30 mm | 4.26 | 943 | 9.43 | 6.96 | 128 |
| Example 8 | | Compound 26 | At 220C° for 30 mm | 4.27 | 990 | 9.90 | 7.28 | 65 |
| Example 9 | High molecular weight compound I + High molecular weight compound II | Compound 1 | At 200C° for 10 min | 3.81 | 850 | 8.50 | 7.01 | 950 |
| Example 10 | | | At 220C° for 30 min | 3.85 | 894 | 8.94 | 7.29 | 412 |
| Comp. Ex. 1 | High molecular weight compound I | Not used | At 200C° for 10 min | 3.97 | 888 | 8.88 | 7.03 | 251 |
| Comp. Ex. 2 | | Not used | At 220C° for 30 min | 4.10 | 896 | 8.95 | 6.86 | 30 |
| Comp. Ex. 3 | High molecular weight compound II | Not used | At 200C° for 10 mm | 4.05 | 920 | 9.19 | 7.13 | 443 |
| Comp. Ex. 4 | | Not used | At 220C° for 30 mm | 4.25 | 1004 | 10.04 | 7.42 | 57 |
| Comp. Ex. 5 | High molecular weight compound I + High molecular weight compound II | Not used | At 200C° for 10 mm | 3.82 | 695 | 6.94 | 5.72 | 830 |
| Comp. Ex. 6 | | Not used | At 220C° for 30 min | 3.90 | 774 | 7.73 | 6.23 | 348 |

As shown in Table 1, regarding the driving voltage with an electric current at a current density of 10 mA/cm², the organic EL elements of Examples in which a thermally crosslinkable low molecular weight compound was added exhibited lower values as compared with the values of the organic EL elements of Comparative Examples. Also, regarding the element service time (an attenuation of 80%), the organic EL elements of Examples in which a thermally crosslinkable low molecular weight compound was added had longer service times as compared with the service times of the organic EL elements of Comparative Examples.

As described above, it has been found that organic EL elements that each include an organic layer formed using the composition for light emitting diodes according to the present invention can achieve a lower voltage and a long service time while maintaining a high efficiency, as compared with conventional organic EL elements.

### Industrial Application

The organic EL element according to the present invention has a low driving voltage and a long service time, and thus can be extended to applications such as, for example, home electric appliances and lighting equipment.

## Claims

1. A composition for light emitting diodes comprising:
a high molecular weight compound; and
a thermally crosslinkable low molecular weight compound,
wherein the thermally crosslinkable low molecular weight compound comprises a compound that has two or more thermally crosslinkable structures in a molecule.

2. The composition for light emitting diodes according to claim 1,
wherein the thermally crosslinkable low molecular weight compound comprises the compound that has two or more thermally crosslinkable structures selected from the group consisting of an acrylate structure, a methacrylate structure, and a maleimide structure in a molecule.

3. The composition for light emitting diodes according to claim 2,
wherein the thermally crosslinkable low molecular weight compound comprises a compound represented by general formula (1) given below,
[Chem. 1]
A-L2-L1-L2-A (1)
where L1 represents an arylene group, a heteroarylene group, an alkylene group, or a disulfide group,
L2 represents an arylene group, a heteroarylene group, a disulfide group, or a single bond, and
A represents a group selected from the group consisting of formula A1, formula A2, and formula A3 given below, and may represent the same or different groups, 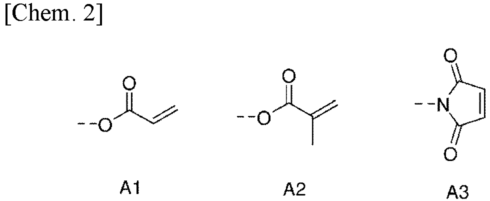
where a broken line indicates a binding site.

4. The composition for light emitting diodes according to claim 3,
wherein, in the general formula (1), L1 represents a phenylene group, a naphthalene group, or a biphenylene group, and L2 represents a single bond, or alternatively, L1 represents an alkylene group having 2 to 6 carbon atoms, and L2 represents a phenylene group or a naphthalene group.

5. The composition for light emitting diodes according to any one of claims 1 to 4,
wherein the high molecular weight compound contains a repeating unit that has a triarylamine structural unit represented by general formula (2) given below, and has a weight-average molecular weight in terms of polystyrene of 10,000 or more and less than 1,000,000, 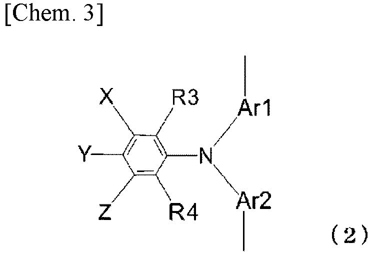
where Ar1 and Ar2 each independently represent an arylene group or a heteroarylene group,
R3 and R4 each independently represent a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms,
X, Y, and Z each independently represent an aryl group, a heteroaryl group, a hydrogen atom, a heavy hydrogen atom, a fluorine atom, a chlorine atom, a cyano group, a nitro group, an alkyl group having 1 to 8 carbon atoms, a cycloalkyl group having 5 to 10 carbon atoms, an alkenyl group having 2 to 6 carbon atoms, an alkyloxy group having 1 to 6 carbon atoms, or a cycloalkyloxy group having 5 to 10 carbon atoms, with the proviso that at least one of X, Y, and Z represents an aryl group or a heteroaryl group.

6. The composition for light emitting diodes according to claim 5,
wherein the high molecular weight compound comprises a copolymerized high molecular weight compound that further contains a repeating unit that has one or more structural units selected from the group consisting of structural units represented by general formulas (3a) to (3x) given below, 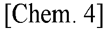 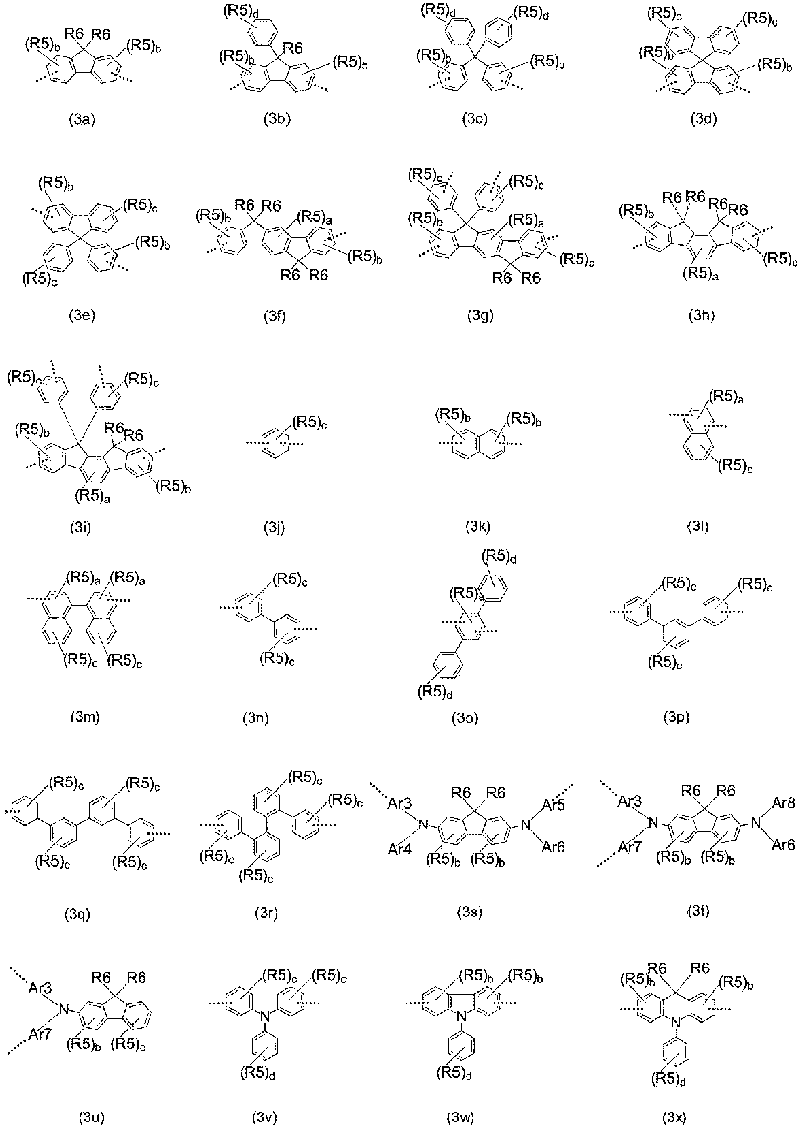
where R5 represents a hydrogen atom, a heavy hydrogen atom, a cyano group, a nitro group, a fluorine atom, a chlorine atom, a bromine atom, an iodine atom, an alkyl group having 1 to 40 carbon atoms, a cycloalkyl group having 3 to 40 carbon atoms, an alkyloxy group having 1 to 40 carbon atoms, a cycloalkyloxy group having 3 to 40 carbon atoms, a thioalkyloxy group having 1 to 40 carbon atoms, an alkenyl group having 2 to 40 carbon atoms, or an aryloxy group having 6 to 40 carbon atoms,
R6 represents an alkyl group having 1 to 40 carbon atoms, a cycloalkyl group having 3 to 40 carbon atoms, an alkyloxy group having 1 to 40 carbon atoms, a thioalkyloxy group having 1 to 40 carbon atoms, or a cycloalkyloxy group having 3 to 40 carbon atoms,
Ar3, Ar5, and Ar7 each independently represent an arylene group or a heteroarylene group,
Ar4, Ar6, and Ar8 each independently represent an aryl group or a heteroaryl group,
a to d represent the number of R5,
a represents an integer of 0 to 2,
b represents an integer of 0 to 3,
c represents an integer of 0 to 4, and
d represents an integer of 0 to 5.

7. The composition for light emitting diodes according to claim 5 or 6,
wherein the high molecular weight compound comprises a copolymerized high molecular weight compound that further contains a repeating unit that has one or more thermally crosslinkable structural units selected from the group consisting of thermally crosslinkable structural units represented by general formulas (4a) to (4z) given below, 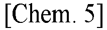 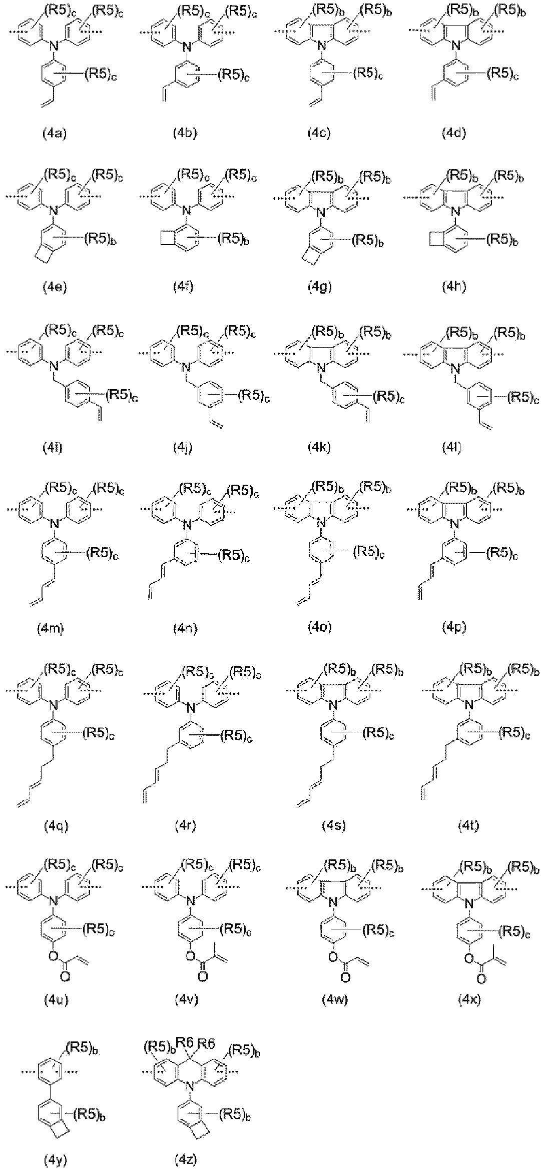
where R5, R6, a, b, and c represent the same as those of the general formulas (3 a) to (3x) given above.

8. The composition for light emitting diodes according to any one of claims 1 to 7,
wherein the high molecular weight compound comprises a high molecular weight compound that contains a repeating unit that has a triarylamine structural unit represented by general formula (5) given below and a repeating unit that has a connecting structural unit represented by general formula (6) given below, and has a weight-average molecular weight in terms of polystyrene of 10,000 or more and less than 1,000,000, 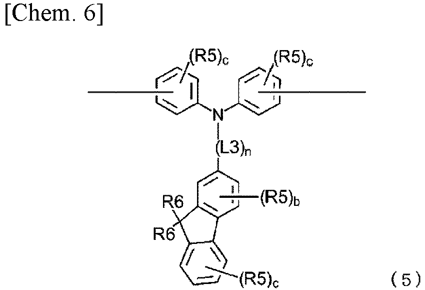 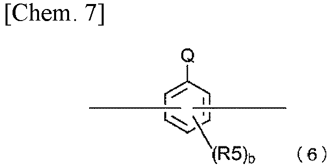
where R5, R6, b, and c represent the same as those of the general formulas (3a) to (3x) given above,
Q represents a hydrogen atom, a heavy hydrogen atom, an amino group, an aryl group, or a heteroaryl group,
L3 represents a phenylene group, and
n represents an integer of 0 to 3.

9. The composition for light emitting diodes according to any one of claims 1 to 8,
wherein the high molecular weight compound comprises a copolymerized high molecular weight compound that contains a repeating unit represented by general formula (7) given below, 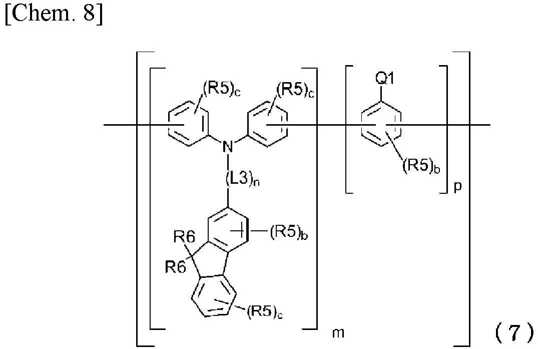
where R5, R6, b, and c represent the same as those of the general formulas (3 a) to (3x) given above,
Q1 represents a hydrogen atom, a heavy hydrogen atom, an amino group, an aryl group, or a heteroaryl group,
L3 represents a phenylene group,
n represents an integer of 0 to 3,
m represents a mole fraction of 0.1 to 0.9, and
p represents a mole fraction of 0.1 to 0.9.

10. The composition for light emitting diodes according to claim 1, comprising two or more high molecular weight compounds.

11. A composition for organic electroluminescent elements, comprising the composition for light emitting diodes according to any one of claims 1 to 10.

12. An organic electroluminescent element comprising:
a pair of electrodes; and
at least one organic layer provided between the pair of electrodes,
wherein the organic layer is formed using the composition for organic electroluminescent elements according to claim 11.

13. The organic electroluminescent element according to claim 12,
wherein the organic layer is a hole transport layer.

14. The organic electroluminescent element according to claim 12,
wherein the organic layer is an electron blocking layer.

15. The organic electroluminescent element according to claim 12,
wherein the organic layer is a hole injection layer.

16. The organic electroluminescent element according to claim 12,
wherein the organic layer is a light emitting layer.
